(19) 

**Europäisches Patentamt**
**European Patent Office**
**Office européen des brevets**

(11) **EP 4 280 837 B1**

(12) **EUROPEAN PATENT SPECIFICATION**

(45) Date of publication and mention
of the grant of the patent:
**06.05.2026 Bulletin 2026/19**

(21) Application number: **23700045.0**

(22) Date of filing: **09.01.2023**

(51) International Patent Classification (IPC):
*H05K 9/00* $^{(2006.01)}$   *H04M 1/02* $^{(2006.01)}$
*H01Q 1/52* $^{(2006.01)}$   *H01Q 1/24* $^{(2006.01)}$

(52) Cooperative Patent Classification (CPC):
**H05K 9/0022; H01Q 1/24; H01Q 1/52; H04M 1/02;**
**H05K 9/00**

(86) International application number:
**PCT/KR2023/000384**

(87) International publication number:
**WO 2023/195604 (12.10.2023 Gazette 2023/41)**

(54) **SHIELDING ASSEMBLY AND ELECTRONIC DEVICE COMPRISING SAME**
ABSCHIRMUNGSANORDNUNG UND ELEKTRONISCHE VORRICHTUNG DAMIT
ENSEMBLE DE BLINDAGE ET DISPOSITIF ÉLECTRONIQUE LE COMPRENANT

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**

(30) Priority: **04.04.2022 KR 20220041927**
**19.08.2022 KR 20220104317**

(43) Date of publication of application:
**22.11.2023 Bulletin 2023/47**

(73) Proprietor: **Samsung Electronics Co., Ltd.**
**Gyeonggi-do 16677 (KR)**

(72) Inventors:
• **CHOI, Taihwan**
**Suwon-si, Gyeonggi-do 16677 (KR)**
• **KIM, Dokyun**
**Suwon-si, Gyeonggi-do 16677 (KR)**
• **KIM, Sanguk**
**Suwon-si, Gyeonggi-do 16677 (KR)**

• **AHN, Kwangseok**
**Suwon-si, Gyeonggi-do 16677 (KR)**
• **LEE, Hanyeop**
**Suwon-si, Gyeonggi-do 16677 (KR)**
• **HWANG, Wongi**
**Suwon-si, Gyeonggi-do 16677 (KR)**
• **LIM, Gun**
**Suwon-si, Gyeonggi-do 16677 (KR)**

(74) Representative: **Gulde & Partner**
**Patent- und Rechtsanwaltskanzlei mbB**
**Berliner Freiheit 2**
**10785 Berlin (DE)**

(56) References cited:
**KR-A- 20170 034 040    KR-A- 20190 024 178**
**KR-A- 20190 102 867    KR-A- 20190 121 469**
**KR-A- 20210 135 817    US-A1- 2010 149 453**
**US-A1- 2012 194 393    US-A1- 2021 168 973**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**BACKGROUND**

**FIELD**

Various embodiments of the disclosure relate to an electronic device.

**DESCRIPTION OF RELATED ART**

In electronic devices, a use of a metal frame is preferred for their mechanical rigidity or high-end design. For example, an electronic device that serves wireless communication, such as e.g., a smart phone, may provide a segment or segmented part in its metal frame, and utilize the metal frame provided with such a segmented part as an antenna.

For the electronic device using the metal frame as an antenna, radiation energy may be concentrated around the segment arranged in the metal frame, and thus, when a metal dielectric is present adjacent to the segment, it may lead to an increased coupling factor in the metal dielectric. When the coupling factor increases, the antenna efficiency in an electronic device may be reduced. Therefore, it may be more advantageous in securing better antenna performance to arrange a metallic material to be spaced apart from the segment of the metal frame as much as possible in its design.

US 2021/168973 Al discloses an electronic device including a housing, and a display disposed to at least part of the housing. The display includes a display panel including at least one pixel, and a substrate layer disposed below the display panel. The substrate layer includes a bendable connecting area extending to the outside of the display panel. The display further includes a display driving circuit disposed to one face of the connecting area, a Flexible Printed Circuit Board (FPCB) electrically coupled with at least part of the connecting area and including a contact area to which a conductor electrically coupled with a ground portion of the electronic device is exposed, and a shielding member electrically coupled with the contact area. The shielding member is disposed on the FPCB and one face of the connecting area to cover at least part of the display driving circuit. The document US2021/168973A1 discloses the preamble of the independent claim 1.

**SUMMARY**

The present invention is defined by the appended set of claims. Preferred embodiments are defined by the dependent claims. An embodiment of the disclosure provides a shielding assembly in which a slit is provided near or in the vicinity of a conductive tape adjacent to the segment or the segmented part in a metal frame on which radiation energy is concentrated, and an electronic device including the same.

The technical problems to be achieved in the present disclosure are not limited to those described above, and other technical problems not mentioned herein may be clearly understood to those having ordinary knowledge in the technical field to which the present disclosure belongs from the description below.

According to an embodiment of the disclosure, provided is an electronic device including a display panel, a printed circuit board, a display driver integrated circuit (DDI), and a shielding tape covering a metal housing. To this end, the electronic device comprises the DDI electrically coupled to the display panel and the printed circuit board, and configured to control driving of the display panel, a frame made of a metal material along an outer rim, and a conductive tape provided to cover the DDI between the DDI and the frame so as to block a radio signal from being transmitted to the DDI. The frame comprises one or more segments (or segmented parts) made of a non-metallic material in order to transmit and receive the radio signal at any position of the outer rim. The conductive tape comprises a slit facing one or more segmented parts and having a predetermined area.

According to various embodiments of the disclosure, it is possible to improve deterioration of antenna performance by removing the conductive tape with a slit shape in vicinity of the segment in an electronic device having the segment in the metal frame.

The effects that can be obtained from the present disclosure are not limited to those described above, and any other effects not mentioned herein will be clearly derived and understood by those having ordinary knowledge in the technical field to which the present disclosure belongs from the following description. That is to say, any unintended effects according to carrying out exemplary embodiments of the disclosure may be clearly derived and understood by those having ordinary knowledge in the technical field from exemplary embodiments of the disclosure.

**BRIEF DESCRIPTION OF THE DRAWINGS**

FIG. 1 is a block diagram of an electronic device in a network environment according to various embodiments of the disclosure;

FIG. 2 is a block diagram of a display module according to various embodiments of the disclosure;

FIG. 3 is a front view of an electronic device according to an embodiment of the disclosure;

FIG. 4 is an exploded perspective view of an electronic device according to an embodiment of the disclosure;

FIGS. 5A and 5B are partial plan views illustrating a case in which a conductive tape covers a flexible printed circuit board (FPCB) in an electronic device according to an embodiment of the disclosure;

FIG. 6 is a side cross-sectional view and a partial perspective view illustrating a noise blocking structure in an electronic device according to an embodiment of the disclosure;

FIGS. 7A and 7B are plan views of an example conductive tape applied to an electronic device according to an embodiment of the disclosure;

FIG. 8 is an exploded perspective view of an electronic device according to an embodiment of the present disclosure;

FIGS. 9A and 9B are partial plan views illustrating a case in which a conductive tape is attached to a bracket in an electronic device according to an embodiment of the present disclosure;

FIGS. 10A and 10B are plan views of an example conductive tape applied to an electronic device according to an embodiment of the present disclosure; and

FIGS. 11A to 11F are partial plan views illustrating a shape of an example slit provided in a conductive tape applied to an electronic device according to an exemplary embodiment.

In the following description, reference is made to the accompanying drawings, wherein specific embodiments for implementing the disclosed invention are illustrated by way of example. Further, other examples may be utilized and structural changes thereof may be made without departing from the scope of various examples.

## DETAILED DESCRIPTION

Hereinafter, with reference to the drawings, various embodiments of the disclosure will be described in detail so that those having ordinary knowledge in the technical field to which the disclosure pertains can easily implement the disclosed invention. However, the disclosure may be implemented in several different forms and is not limited to the embodiments described herein. In conjunction with the description of the drawings, like or similar reference numerals may be used for such like or similar components. Further, in the drawings and their related descriptions, descriptions of well-known functions and configurations may be omitted for clarity and conciseness.

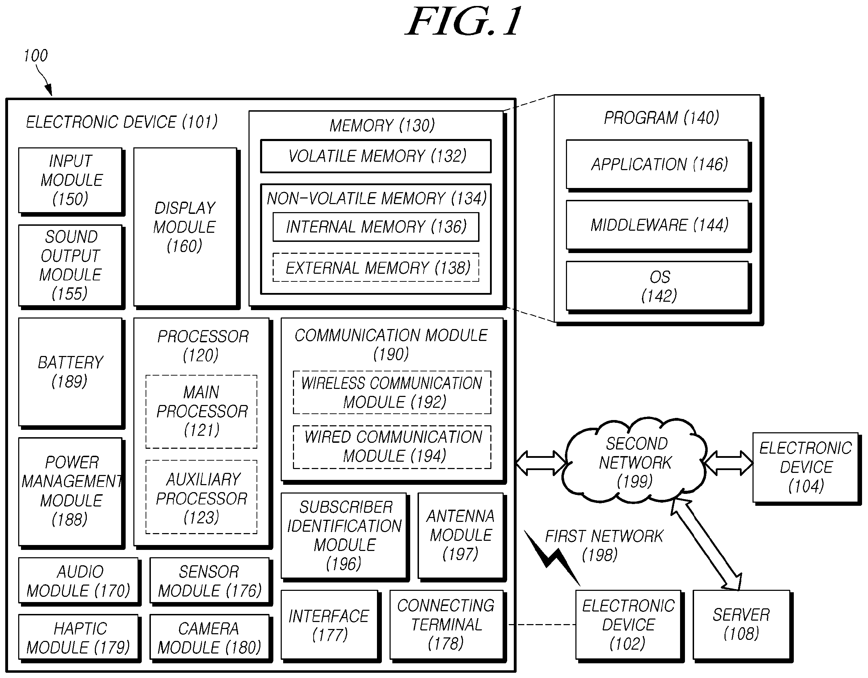

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth™, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

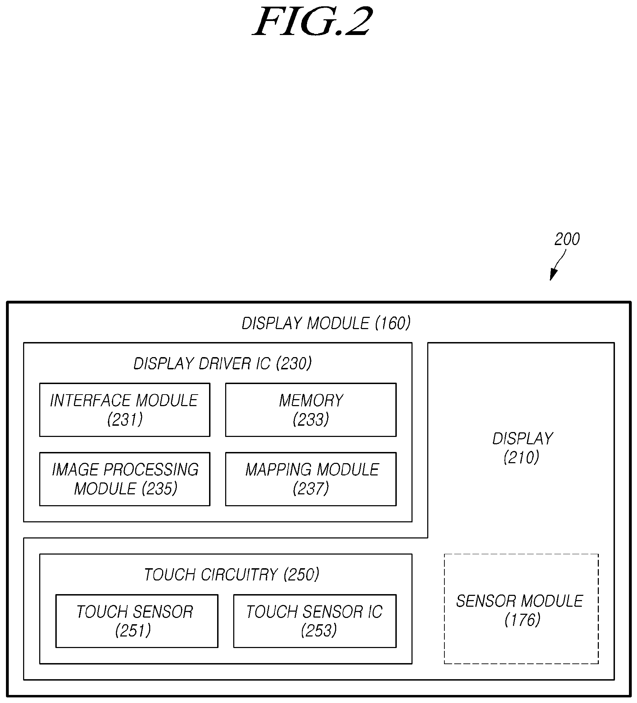

FIG. 2 is a block diagram 200 illustrating the display module 160 according to various embodiments.

Referring to FIG. 2, the display module 160 includes a display 210 and a display driver integrated circuit (DDI) 230 to control the display 210. The DDI 230 may include an interface module 231, memory 233 (e.g., buffer memory), an image processing module 235, or a mapping module 237. The DDI 230 may receive image information that contains image data or an image control signal corresponding to a command to control the image data from another component of the electronic device 101 via the interface module 231. For example, according to an embodiment, the image information may be received from the processor 120 (e.g., the main processor 121 (e.g., an application processor)) or the auxiliary processor 123 (e.g., a graphics processing unit) operated independently from the function of the main processor 121. The DDI 230 may communicate, for example, with touch circuitry 250 or the sensor module 176 via the interface module 231. The DDI 230 may also store at least part of the received image information in the memory 233, for example, on a frame by frame basis. The image processing module 235 may perform pre-processing or post-processing (e.g., adjustment of resolution, brightness, or size) with respect to at least part of the image data. According to an embodiment, the pre-processing or post-processing may be performed, for example, based at least in part on one or more characteristics of the image data or one or more characteristics of the display 210. The mapping module 237 may generate a voltage value or a current value corresponding to the image data pre-processed or post-processed by the image processing module 235. According to an embodiment, the generating of the voltage value or current value may be performed, for example, based at least in part on one or more attributes of the pixels (e.g., an array, such as an RGB stripe or a pentile structure, of the pixels, or the size of each subpixel). At least some pixels of the display 210 may be driven, for example, based at least in part on the voltage value or the current value such that visual information (e.g., a text, an image, or an icon) corresponding to the image data may be displayed via the display 210.

According to an embodiment, the display module 160 may further include the touch circuitry 250. The touch circuitry 250 may include a touch sensor 251 and a touch sensor IC 253 to control the touch sensor 251. The touch sensor IC 253 may control the touch sensor 251 to sense a touch input or a hovering input with respect to a certain position on the display 210. To achieve this, for example, the touch sensor 251 may detect (e.g., measure) a change in a signal (e.g., a voltage, a quantity of light, a resistance, or a quantity of one or more electric charges) corresponding to the certain position on the display 210. The touch circuitry 250 may provide input information (e.g., a position, an area, a pressure, or a time) indicative of the touch input or the hovering input detected via the touch sensor 251 to the processor 120. According to an embodiment, at least part (e.g., the touch sensor IC 253) of the touch circuitry 250 may be formed as part of the display 210 or the DDI 230, or as part of another component (e.g., the auxiliary processor 123) disposed outside the display module 160.

According to an embodiment, the display module 160 may further include at least one sensor (e.g., a fingerprint sensor, an iris sensor, a pressure sensor, or an illuminance sensor) of the sensor module 176 or a control circuit for the at least one sensor. In such a case, the at least one sensor or the control circuit for the at least one sensor may be embedded in part of the display module 160 (e.g., the display 210, the DDI 2300) or part of the touch circuitry 250. For example, when the sensor module 176 embedded in the display module 160 includes a biometric sensor (e.g., a fingerprint sensor), the biometric sensor may obtain biometric information (e.g., a fingerprint image) corresponding to a touch input received via a portion of the display 210. As another example, when the sensor module 176 embedded in the display module 160 includes a pressure sensor, the pressure sensor may obtain pressure information corresponding to a touch input received via a partial or whole area of the display 210. According to an embodiment, the touch sensor 251 or the sensor module 176 may be disposed between pixels in a pixel layer of the display 210, or over or under the pixel layer.

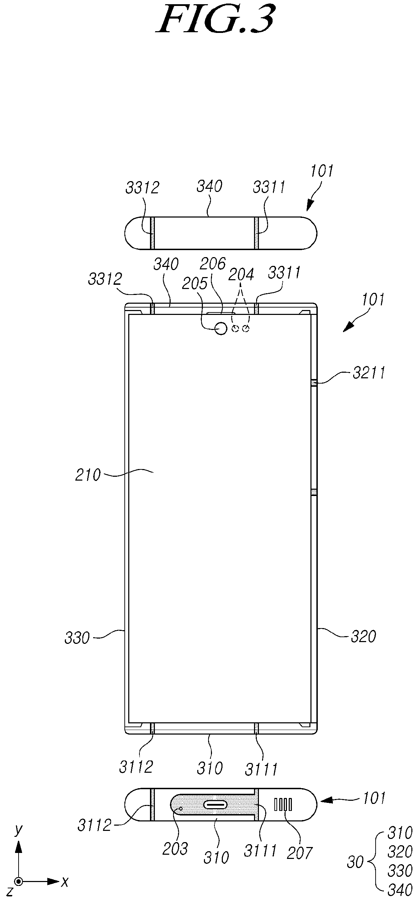

FIG. 3 is a front view of an electronic device (e.g., the electronic device 101 of FIG. 1) according to an embodiment of the disclosure.

Referring to FIG. 3, according to the invention, the electronic device 101 includes a frame 30 and a display 210. The frame 30 may include a first frame 310 (e.g., a lower frame), a second frame 320 (e.g., a right frame), a third frame 330 (e.g., a left frame) or a fourth frame 340 (e.g., an upper frame). The first frame 310 may face in a direction opposite to the fourth frame 340 and/or may be arranged orthogonally to the second frame 320 and the third frame 330. To this end, the second frame 320 may face in a direction opposite to third frame 330. The frame 30 may be made of a metal material. The display 210 may be disposed in a front surface of the electronic device 101 to be supported through at least part of the frame 30.

According to an embodiment, the electronic device 101 may include a front surface, a rear surface (not shown) facing in a direction opposite to the front surface, or a side surface surrounding a space between the front surface and the rear surface (not shown). The side surface may be at least one of an upper side surface, a lower side surface, a left side surface, or a right side surface with respect to the front side. However, it is only of an example, and may have a surface corresponding to one or two of the four surfaces of the frame 30. Hereinafter, for convenience of description, description is made of a case of three surfaces as an example.

According to an embodiment, the electronic device 101 may comprise at least one of an input module (e.g., the input module 150 of FIG. 1) including a microphone 203, a sound output module (e.g., the sound output module 155 of FIG. 1) including a receiver 206 and/or a speaker 207, a sensor module including a front sensor 204 (e.g., the sensor module 176 of FIG. 1), a camera module (e.g., the camera module 180 of FIG. 1) including a first camera module 205 arranged on the front surface, a connector port (e.g., the connection terminal 178 of FIG. 1), and/or an indicator (not shown). The electronic device 101 may be configured such that at least one of the above-described components is omitted or other components are added thereto.

According to an embodiment, the input module 150 may include one or more microphones (e.g., the microphone 203) arranged to detect a direction of sound. The sound output module (e.g., the sound output module 155 of FIG. 1) may include, for example, the receiver 206 for a call and/or the speaker 207. The receiver 206 for a call may include a speaker (e.g., a piezo speaker) that is operable with a separate speaker hole being excluded.

According to an embodiment, the sensor module 176 may generate an electrical signal or data value corresponding to an internal operating state or an external environmental condition of the electronic device 101. The sensor module 176 may include at least one of a proximity sensor, an illuminance sensor, a time-of-flight (TOF) sensor, an ultrasonic sensor, a fingerprint recognition sensor, a gesture sensor, a gyro sensor, a barometric pressure sensor, a magnetic sensor, an acceleration sensor, a grip sensor, a color sensor, an infrared (IR) sensor, a bio-sensor, a temperature sensor, a humidity sensor or any combination thereof. The front sensor 204 that may be included in the sensor module 176 may include, for example, at least one of a proximity sensor, an illuminance sensor, a TOF sensor, an ultrasonic sensor or any combination thereof.

According to an embodiment, the camera module 180 may include a first camera module 205 disposed on the front surface of the electronic device 101 and/or a second camera module (not shown) disposed on the rear surface (not shown). The first camera module 205 and/or the second camera module may include one or more lenses, an image sensor, and/or an image signal processor. For example, the first camera module 205 may be disposed under the display 210 and may be configured to capture a subject through a portion of an active area of the display 210. A flash may be disposed in the second camera module. The flash may include, for example, a light emitting diode (LED) or a xenon lamp.

According to an embodiment, the first camera module 205 that is one of the camera modules 180, or the front sensor 204 that is a part of the sensor module 176 may be arranged to detect the external environment through the display 210. An area of the display 210 provided with the first camera module 205 may be, for example, formed as a transmissive area having a designated transmittance as a portion of an area displaying contents. The transmissive area may be formed to have, for example, a transmittance in a range of about 5% to about 20%. Such a transmissive area may include an area overlapping an effective area (e.g., an angle of view area) of the first camera module 205, through which light passes to be imaged by an image sensor to obtain an image. For example, the transmissive area of the display 210 may include an area having lower pixel density and/or wiring density than the surrounding area. The camera module 180 may include an under display camera (UDC). The sensor module 176 may be arranged to perform its function without being visibly exposed through the display 210 from the internal space of the electronic device 101.

According to an embodiment, the electronic device 101 may include at least one antenna (e.g., an antenna radiator or the antenna module 197 of FIG. 1) electrically connected to a wireless communication circuit (e.g., the wireless communication module 192 of FIG. 1). The at least one antenna may include at least one of a first antenna disposed on the first frame 310 of the frame 30, a second antenna disposed on the second frame 320 or the third frame 330, a third antenna disposed on the fourth frame 340 or any combination thereof.

According to an embodiment, a first conductive portion provided in the first frame 310 of the electronic device 101 may operate as a first antenna, the first conductive portion being segmented by at least one segment 3111 and/or 3112 which is a non-conductive portion. Being segmented by at least one segment 3111, 3112 may be understood as the first conductive portion of the first frame 310 being divided into at least two portions separated, in particular completely separated, from each other by the at least one segment 3111, 3112. The first conductive portion may be, for example, arranged to be segmented by a first segment 3111 and/or a second segment 3112 spaced apart from each other at a designated interval. The first conductive portion may be electrically connected to the wireless communication circuit (e.g., the wireless communication module 192 of FIG. 1).

According to an embodiment, a second conductive portion provided in the third frame 330 of the electronic device 101 may operate as a second antenna, the second conductive portion being segmented by at least one segment 3211 which is a non-conductive portion. Being segmented by at least one segment 3211 may be understood as the second conductive portion of the third frame 330 being divided into at least two portions separated, in particular completely separated, from each other by the at least one segment 3211. The second conductive portion may be, for example, arranged to be segmented by a third segment 3211 and/or a fourth segment (not shown) spaced apart at a designated interval. The second conductive portion may be electrically connected to the wireless communication circuit (e.g., the wireless communication module 192 of FIG. 1).

According to an embodiment, a third conductive portion provided in the fourth frame 340 of the electronic device 101 may operate as a third antenna, the third conductive portion being segmented by at least one segment 3311 and/or 3312 which is a non-conductive portion. Being segmented by at least one segment 3311, 3312 may be understood as the third conductive portion of the fourth frame 340 being divided into at least two portions separated, in particular completely separated, from each other by the at least one segment 3311, 3312. The third conductive portion may be, for example, arranged to be segmented by a fifth segment 3311 and/or a sixth segment 3312 spaced apart at a designated interval. Further, the third conductive portion may be electrically connected to the wireless communication circuit (e.g., the wireless communication module 192 of FIG. 1).

According to an embodiment, the wireless communication circuit (e.g., the wireless communication module 192 of FIG. 1) of the electronic device 101 may be configured to transmit and/or receive a radio signal in a designated first frequency band (e.g., about 800 MHz to 6000 MHz) through at least one of the first conductive portion, the second conductive portion, and/or the third conductive portion. The wireless communication circuit (e.g., the wireless communication module 192 of FIG. 1) of the electronic device 101 may be configured to transmit and/or receive a radio signal in a designated second frequency band (e.g., about 3 GHz to 100 GHz) through at least one of the first conductive portion, the second conductive portion, and/or the third conductive portion. The electronic device 101 may further include at least one antenna module for transmitting and/or receiving a signal in the first frequency band or at least one antenna module (e.g., a 5G antenna module or an antenna structure) for transmitting and/or receiving a signal in the second frequency band.

Although not shown therein, the electronic device 101 according to an embodiment may include a flexible display (e.g., the display module 160 of FIG. 1) with slidable or rollable coupling, which may include, for example, an expandable display, a stretchable display, a rollable display, a display assembly or the like. The flexible display (not shown) may have a structure in which at least two housings are stacked on each other with the front/rear surfaces so as to be slidable in a certain direction (e.g., in left/right direction or up/down direction). The flexible display (not shown) may be, for example, configured to have a variable display area in use, as one housing slides along the other housing in a certain direction (e.g., in the left/right direction or in the up/down direction). One or more segments for serving as an antenna may be also provided in a frame in the electronic device 101 including the flexible display.

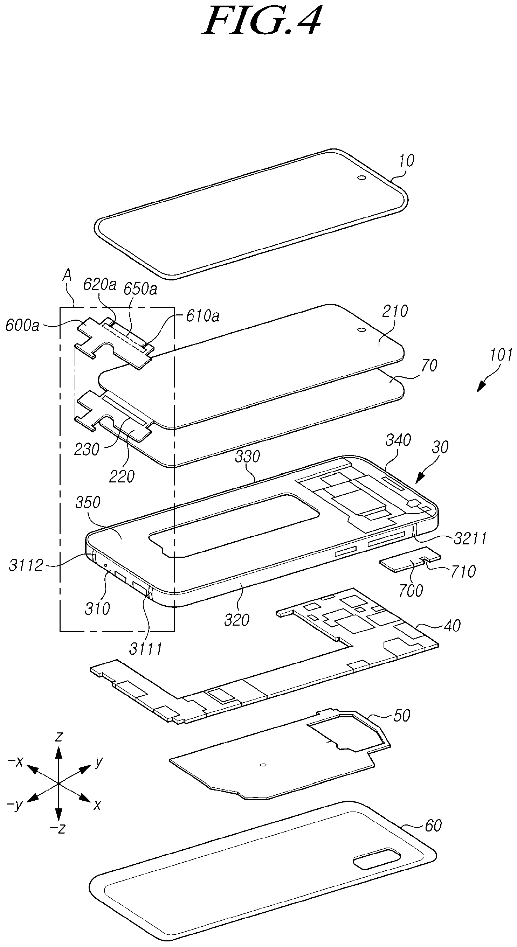

FIG. 4 is an exploded perspective view of an electronic device (e.g., the electronic device 101 of FIG. 1) according to an embodiment.

Referring to FIG. 4, the electronic device 101 according to an embodiment may include a front plate 10 and/or a rear cover 60. The electronic device 101 may be arranged with a display 210, a conductive layer 70, a frame 30, a PCB 40, and/or a rear case 50, being arranged in an inner space formed in between the front plate 10 and the rear cover 60, in a direction (e.g., -z direction) from the top to the bottom with respect to z-axis. The conductive layer 70 may be disposed between the display 210 and the frame 30, or between the display 210 and the PCB 40, for example. In such a case, the conductive layer 70 can prevent an electrical signal generated from the DDI 230 or the PCB 40 from affecting the display 210.

According to an embodiment, various components may be mounted on the PCB 40 using an electrical coupling method such as e.g., soldering, and the mounted components may be electrically connected to each other by electrical lines according to a predetermined pattern. The PCB 40 may be, for example, electrically connected to a flexible printed circuit board (FPCB or flexible PCB) 220, on which the DDI 230 is mounted, and/or a camera module (e.g., the camera module 180 of FIG. 1). The FPCB 220 and/or the camera module 180 may be at least partially covered by a conductive tape 600a and/or a conductive sheet 700 after being electrically connected to the PCB 40. In some embodiments, at least one other component (e.g., the battery 189, the audio module 180 or the haptic module 179 of FIG. 1) amongst the components omitted or not shown in FIG. 4 may be further mounted onto the PCB 40 as an additional component.

According to an embodiment, at least a portion of the front plate 10 may be formed to be substantially transparent. The front plate 10, at least part of which is substantially transparent, may be formed of, for example, a glass plate or a polymer plate including various coating layers.

According to an embodiment, the display 210 may be exposed through a substantial portion of the front plate 10. In some embodiments, at least part of the display 210 may be exposed through the front plate 10. According to an embodiment, in order to expand an area through which the display 210 is exposed, a distance between outer edges of the display 210 and a distance between outer edges of the front plate 10 may be substantially the same as each other. Further, the display 210 may further include a touch panel for receiving a user input. The user input (e.g., a touch input) may be received through the touch panel.

According to an embodiment, the frame 30 may be a side housing constituting a rim of the electronic device 101. According to an embodiment, the frame 30 may be configured to protect various components arranged in the electronic device 101. For example, the components such as e.g., the PCB 40 or a battery (not shown) may be seated in a space formed by the frame 30, the rear cover 60, or the display 210. The frame 30 may protect the components disposed therein from any external impact. The frame 30 may be made of, for example, a metallic material (e.g., aluminum, stainless steel (STS), or magnesium). The frame 30 may be coupled to the front plate 10 and/or the rear cover 60. The frame 30 may include, for example, a first frame 310, a second frame 320, a third frame 330, or a fourth frame 340. The first frame 310 may be, for example, a frame located on the lowermost side when the electronic device 101 is viewed from +z direction to -z direction with respect to the z-axis. The second frame 320 may be, for example, a frame located on the rightmost side when the electronic device 101 is viewed from +z direction to -z direction with respect to the z-axis. The third frame 330 may be, for example, a frame located on the leftmost side when the electronic device 101 is viewed from +z direction to -z direction with respect to the z-axis. The fourth frame 340 may be, for example, a frame located on the uppermost side when the electronic device 101 is viewed from +z direction to -z direction with respect to the z-axis. Both ends of the first frame 310 may be in contact with one end of the second frame 320 and one end of the third frame 330. Further, both ends of the fourth frame 340 may come into contact and be connected with the other end of the second frame 320 and the other end of the third frame 330.

According to the invention, the frame 30 includes segments or segmented parts (e.g., the first, second, third, fourth, or fifth segments 3111, 3112, 3211, 3311 and 3312). The segments may be positioned in the first frame 310, the second frame 320, the third frame 330, and/or the fourth frame 340. The frame 30 having the segments 3111, 3112, 3211, 3311 and 3312 is used as an antenna for transmitting or receiving a radio signal in a designated frequency band. When a metallic material of the frame 30 is used as an antenna, a gap formed in the frame 30 may refer to each of the segments 3111, 3112, 3211, 3311 or 3312. In at least one of an upper end, a lower end, a left-side end, or a right-side end of the electronic device 101 may be arranged two segments constituting and corresponding to a so-called 'two-segmentation structure'. The number of segments of the electronic device 101 may be determined, for example, depending on the design or performance of the antenna. According to an embodiment, when the electronic device 101 provides the 5G communication service, the segments (e.g., the third segment 3211 of FIG. 3) may be disposed in one side of the frame 30 in order to implement a multiple antenna (e.g., MIMO antenna).

According to an embodiment, the electronic device 101 may be configured to partially insulate the metallic material, for example, a conductive material, of the frame 30 to use it as an antenna. For example, the segments 3111, 3112, 3211, 3311 or 3312 may be formed in a portion of the frame 30 to be used as an antenna. When at least a portion of the frame 30 is used as an antenna, a feeder (not shown) may be independently electrically connected, for example, to at least one or each of two segments (e.g., the first and second segments 3111 and 3112 or the fifth and sixth segment 3311 and 3312 of FIG. 3). The feeder may be configured to transmit a transmission signal output from a communication module (e.g., a front-end module (FEM), RFIC, etc.) to an antenna, or transmit a radio signal received by the antenna to the communication module. The feeder may be arranged in consideration of impedance matching between the antenna and the communication module. In the case of supporting a plurality of frequency bands, the electronic device 101 may include a plurality of power feeders. In such a case, each of the plurality of power feeders may be electrically connected to a corresponding segment.

According to an embodiment, the radiation energy of the antenna in the segments 3111, 3112, 3211, 3311 or 3312 of the frame 30 may be substantially proportional to E-field and H-field as seen in the equation 1 below.

$$\mathbf{W}_{av}(x, y, z) = [\mathcal{W}(x, y, z; t)]_{av} = \tfrac{1}{2}\mathrm{Re}[\mathbf{E} \times \mathbf{H}^*] \qquad (\text{Equation 1})$$

The above equation 1 defines a relationship between the radiation energy and the field, wherein $\mathbf{W}_{av}(x, y, z)$ means the average radiation energy, E means the E-field, and then, **H** means the H-field. According to the equation 1, it can be seen that the radiation energy is proportional to the scalar value of the electric field and the scalar value of the magnetic field. Antenna performance of the electronic device 101 may depend on the strength of the electric field and the magnetic field as seen in the equation 1 above. In general, due to the structure of the electronic device 101, the radiation energy may be concentrated onto the segments.

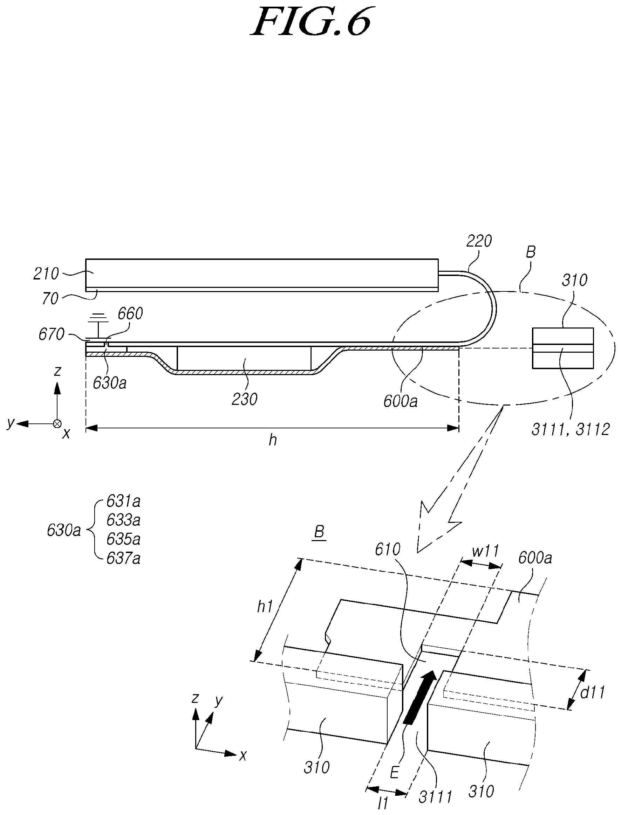

According to an embodiment, the segments 3111, 3112, 3211, 3311 and 3312 may be configured in various shapes. The segments 3111, 3112, 3211, 3311 and 3312 may have a predetermined horizontal width, respectively. For example, the segments 3111, 3112, 3211, 3311 and 3312 may have a width of approximately 0.1 mm to 4.0 mm, in particular approximately 0.5 mm to 2.0 mm, particularly preferred approximately 1.0 mm to 1.5 mm or approximately 1.25 mm. In case where the segments 3111, 3112, 3211, 3311 and 3312 of the frame 30 made of a conductive material serve as an antenna, the radiant energy (e.g., energy E of FIG. 6) may be concentrated onto the segments 3111, 3112, 3211, 3311 and 3312.

According to an embodiment, the first segment 3111 and/or the second segment 3112 may be formed at a predetermined interval in the first frame 310. The first segment 3111 and/or the second segment 3112 may be formed of, for example, a non-metal material, such as a non-conductive material, or an empty space.

According to an embodiment, the third segment 3211 and/or an additional segment (not shown) may be formed at a predetermined interval in the second frame 320. The third segment 3211 and/or the additional segment may be formed of , for example, a non-metal material, such as a non-conductive material, or an empty space.

According to an embodiment, the fifth segment 3311 and/or the sixth segment 3312 may be formed at a predetermined interval in the fourth frame 340. The fifth segment 3311 and/or the sixth segment 3312 may be formed of, for example, a non-metal material, such as a non-conductive material, or an empty space.

According to an embodiment, the PCB 40 may include a plurality of elements for the operation of the electronic device 101. The plurality of devices may be arranged on the PCB 40. The plurality of elements disposed on the PCB 40 may be electrically connected to each other. A plurality of electrically connected elements may be divided into modules for implementing each function of the electric device 101. The plurality of devices may include, for example, an application processor (AP) and a communication processor (CP). Throughout the present disclosure, the PCB 40 may be referred to as a main board or a printed board assembly (PBA). The PCB 40 may include, for example, a plurality of PCBs. The plurality of PCBs 40 may include, for example, a main PCB and a sub PCB. The plurality of PCBs 40 may be electrically connected to each other. The PCB 40 may be electrically connected to the FPCB 220, for example. The FPCB 220 may be bent with a predetermined elasticity. For example, when the PCB 40 is connected to another component (e.g., the display 210), it may be connected using the FPCB 220.

According to an embodiment, a connector may be arranged on both sides of the FPCB 220. The connector may provide electrical coupling with other components (e.g., the PCB 40 or the display 210). For example, the FPCB 220 may be electrically coupled to the connector arranged on the display 210 via a connection part (e.g., a first connector) provided on one side thereof, and may be electrically coupled to a connector arranged on the PCB 40 via another connection part (e.g., a second connector) provided on the other side. In this case, the PCB 40 may have an electrical connection with the display 210 via the FPCB 220.

According to an embodiment, the PCB 40 may include a communication module (e.g., the communication module 190 of FIG. 1). In other words, the communication module 190 may be disposed on the PCB 40. The communication module 190 may include a wireless communication module (e.g., the wireless communication module 192 of FIG. 1) and a wired communication module (e.g., the wired communication module 194 of FIG. 1). The communication module 190 may be configured to, for example, transmit or receive a signal by feeding power to an antenna module (e.g., the antenna module 197 of FIG. 1). Throughout the disclosure, the term "feeding (or feed)" may refer to an operation in which the communication circuitry applies current having a specific frequency to the antenna module 197. The PCB 40 may include a ground area (or a ground plane). The ground area may be formed with at least one layer of a plurality of layers of the PCB 40. The ground area may be electrically connected to the antenna module 197 to form an electrical path for transmitting or receiving the signal.

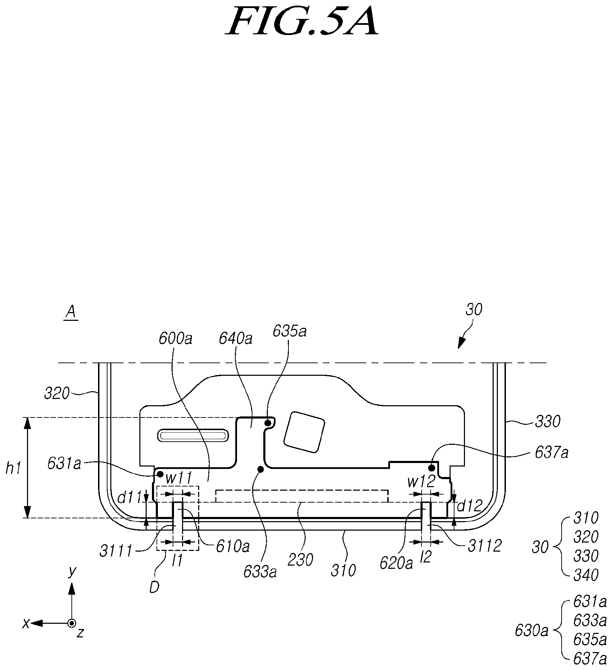

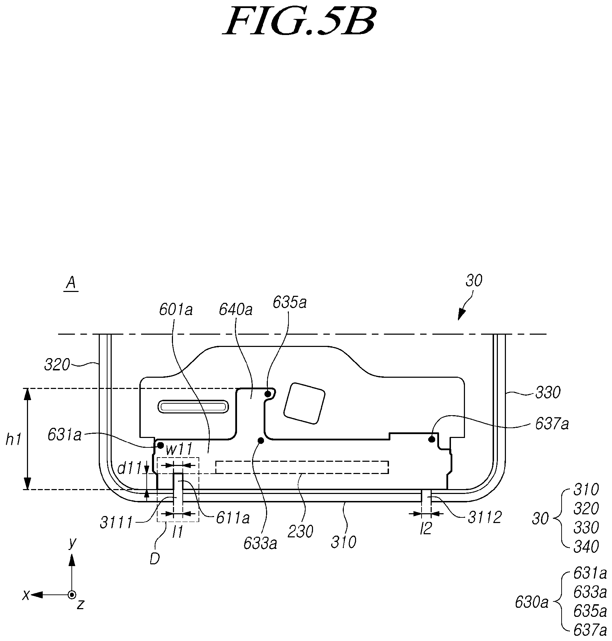

According to the invention, the DDI 230 is electrically connected to the FPCB 220 and the display 210. The DDI 230 may serve to drive each pixel of the display 210. The DDI 230 may be configured to, for example, receive an electrical signal from the AP of the electronic device 101 (e.g., the main processor 121 of FIG. 1) to generate and control a signal for operating the display panel. The DDI 230 may be disposed in a predetermined region on a front surface of the FPCB 220 (e.g., the upper surface of the FPCB 220 of FIG. 4). The DDI 230 may be arranged, for example, in various ways. The DDI 230 may be disposed, for example, in chip-on-glass (COG), chip-on-film (COF), or chip-on-plastic (COP) methods. Depending on the arrangement method of the DDI 230, the first conductive tape 600a may be provided to shield the DDI 230. The first conductive tape 600a may be electrically coupled with a grounding point (e.g., a plurality of grounding points 631a, 633a, 635a and 637a of FIGS. 5A or 5B) provided on the FPCB 220. The grounding points 631a, 633a, 635a and 637a arranged on the FPCB 220 may be electrically connected to the ground area (e.g., the ground area 670 of FIG. 6). The FPCB 220 may be provided with a via hole (e.g., a via hole 660 of FIG. 6) for connecting the grounding points 631a, 633a, 635a and 637a to the ground area 670. In this case, the inside of the via hole 660 may be filled with a conductive material or its inner surface may be made of a conductive material. The conductive material provided in the via hole 660 may serve as a path for electrically connecting the grounding points 631a, 633a, 635a and 637a and the ground area 670. The grounding points 631a, 633a, 635a and 637a and the via hole 660 may form, for example, a path for electrically connecting the first conductive tape 600a to the ground area 670.

According to an embodiment, the first conductive tape 600a is disposed within a space formed by the frame 30, the front plate 10, the display 210, or the back cover 60, so as to shield the DDI 230. According to an embodiment, the first conductive tape 600a may be attached onto one surface of the FPCB 220 to which the DDI 230 is electrically connected. The first conductive tape 600a is provided to cover the DDI 230 or the FPCB 220 on which the DDI 230 is mounted.

According to the invention, the first conductive tape 600a is formed to cover the DDI 230 and/or the FPCB 220. For example, the first conductive tape 600a may come into contact with the grounding points 631a, 633a, 635a and 637a formed on the FPCB 220 to be electrically coupled thereto. As such, the first conductive tape 600a may be connected to the ground area 670 through the grounding points 631a, 633a, 635a and 637a of the FPCB 220. The first conductive tape 600a may be disposed in a direction (e.g., +y direction) normal to an inner surface of the lower end of the frame 30 (e.g., the first frame 310) and substantially parallel to the display 210, in other words, in the direction parallel to an x-y plane. The shielding structure with the first conductive tape 600a may be more advantageous for noise shielding as the larger space is secured. For this reason, for the electronic device 101, the first conductive tape 600a may be attached as widely as possible within a range of allowable design. When the first conductive tape 600a is applied, the first conductive tape 600a may be disposed at a position of either the first segment 3111 or the second segment 3112 in the electronic device 101. In such a case, it may lead to deterioration in the antenna performance, and thus, it may be preferable not to place the conductive material (e.g., the first conductive tape 600a) in the vicinity of the first or second segments 3111 and 3112. Due to the limited internal space of the electronic device 101, a separated distance of the first conductive tape 600a from the first or second segments 3111 and 3112 may be limited, so that one or more slits 610a and 620a may be formed by removing part of the first conductive tape 600a positioned around the first segment 3111 or the second segment 3112. The one or more slits 610a and 620a can prevent deterioration in the antenna performance due to removal of the conductive tape. The number of segments 3111 and 3112 provided in the first frame 310 may be equal to or greater than the number of a plurality of slits 610a and 620a.

According to an embodiment, the first conductive tape 600a covering the DDI 230 may be made in various forms capable of shielding the DDI 230, depending on the arrangement method (e.g., COG, COF or COP method) of the DDI 230. The first conductive tape 600a may be, for example, electrically connected to a plurality of grounding points provided in the FPCB 220 (e.g., the grounding points 631a, 633a, 635a and 637a of FIGS. 5A, 5B or 6). The plurality of grounding points 631a, 633a, 635a and 637a may be electrically connected to a ground area (e.g., the ground area 670 of FIG. 6) through a via hole (e.g., the via hole 660 of FIG. 6) provided in the FPCB 220. In this case, the first conductive tape 600a may be grounded to the ground area 670 through a passage including the plurality of grounding points 631a, 633a, 635a and 637a and a via hole 660. The first conductive tape 600a may be made to cover a larger area of the FPCB 220 including a region to which the DDI 230 is attached. The first conductive tape 600a may be made of, for example, a conductive material including a metal (e.g., a thin sheet (or plate) including copper (Cu) or graphite). The first conductive tape 600a made of a conductive material makes it possible to prevent or at least alleviate deterioration in performance of the antenna owing to attenuation of the intensity of radiation energy (e.g., the energy E of FIG. 6) formed in the first and/or second segments 3111 and 3112. For example, the first conductive tape 600a can shield noise in the display 210 so that the radiation energy (e.g., the energy E of FIG. 6) does not cause deterioration in performance due to low-frequency noise of the DDI 230.

According to an embodiment, the first conductive tape 600a may be electrically coupled to the grounding points 631a, 633a, 635a and 637a provided in the FPCB 220. The grounding points 631a, 633a, 635a and 637a provided in the FPCB 220 may be electrically connected to the ground area 670. The FPCB 220 may be provided with a via hole 660 for connecting the grounding points 631a, 633a, 635a and 637a to the ground area 670. In this case, the via hole 660 may be filled with a conductive material, or an inner surface thereof may be made of a conductive material. The conductive material provided in the via hole 660 may serve as a passage for electrically connecting the grounding points 631a, 633a, 635a and 637a to the ground area 670.

According to the invention, the first conductive tape 600a includes at least one slit 610a or 620a. The slits 610a and 620a may be formed as an empty space of the first conductive tape 600a. Empty is to be understood in the sense that no material (except air) is provided into the slits 610a and 620a. The slits 610a and 620a may be provided, for example, to have a predetermined area at one end facing an inner surface of the at least one segment 3111 or 3112. The slits 610a and 620a may have various shapes other than a square shape. The slits 610a and 620a may have, for example, a shape in which one end facing the inner surface of the segment 3111 and 3112 has a relatively wider width than the other end. One end of the at least one slit 610a or 620a (e.g., one end facing the segments 3111 and 3112) may have, for example, a width equal to or greater than the width in a horizontal direction (e.g., x-axis direction) of the segments 3111 and 3112.

According to the invention, as a result of arranging the segments 3111 and 3112 or the slits 610a and 620a in alignment, it is possible to reduce the loss in an electrical signal radiated from the antenna. According to an embodiment, when the first conductive tape 600a covers the DDI 230, an attachment part 650a may be provided to correspond to a partial area of the first conductive tape 600a covering the DDI 230.

According to an embodiment, the conductive sheet 700 may be configured to cover a rear camera module (e.g., the second camera module of FIG. 3). The conductive sheet 700 may have a larger area including an area corresponding to the rear camera module. The conductive sheet 700 may be made of, for example, a conductive material including a metal (e.g., a thin film sheet (or plate) including copper or graphite). The conductive sheet 700 may include at least one slit 710. The slit 710 may be formed at a position aligned with the third segment 3211 of the right frame 320. The slit 710 may be formed of, for example, a non-metal material, such as a non-conductive material, or an empty space. As a result of the alignment between the slit 710 and the third segment 3211, it is possible to prevent or at least alleviate deterioration in antenna performance due to attenuation of the intensity of radiation energy in the third segment 3211.

According to an embodiment, the first conductive tape 600a or the conductive sheet 700 may be provided to shield a target component corresponding to at least one of the DDI 230 or the camera module (e.g., the camera module 180 of FIG. 1). The first conductive tape 600a or the conductive sheet 700 may have an area enough to form a surplus area to provide an extra space around the area covering the target component (e.g., the DDI 230 or the camera module 180). The conductive tape 600 or the conductive sheet 700 may be configured to be electrically connected to the ground area (e.g., the ground area 670 of FIG. 6) provided in the electronic device 101 at a plurality of positions (e.g., the grounding point 630a of FIG. 5A) arranged in the FPCB 220 or the PCB 40.

According to the invention, a part of the frame 30 or a combination thereof form an antenna structure. The antenna may include, for example, a near field communication (NFC) antenna, a wireless charging antenna, and/or a magnetic secure transmission (MST) antenna. The antenna may serve to, for example, perform short-range communication with an external device or wirelessly transmit/receive power required for charging.

According to an embodiment, the conductive layer 70 may be disposed on the rear surface of the display 210, for example. The conductive layer 70 may include, for example, a thin film sheet (or plate) made of copper or graphite. The conductive layer 70 may have, for example, an area equal to the size of the display 210 area. The conductive layer 70 may prevent a malfunction (e.g., flickering) from occurring in the display 210, for example, due to the noise in the DDI 230. For example, the FPCB 220 to which the DDI 230 is attached may be electrically connected to the display 210 and attached to the rear surface of the conductive layer 70. According to an embodiment, the conductive layer 70 may be configured as a part of the display 210.

According to an embodiment, the electronic device 101 may include a rear cover 60. The rear cover 60 may be disposed in contact with at least a portion of the frame 30 on the rear surface of the electronic device 101. The back cover 60 may be formed of, for example, polymer, coated or colored glass, ceramic, metal (e.g., aluminum, stainless steel (STS), or magnesium), or a combination of at least two of these materials.

FIGS. 5A and 5B are partial plan views illustrating a configuration (indicated by A) in which the conductive tape (e.g., the first conductive tape 600a of FIG. 4) covers the FPCB (e.g., the FPCB 220 of FIG. 4) in an electronic device (e.g., the electronic device 101 of FIG. 1) according to an embodiment of the disclosure.

Referring to FIG. 5A, a first segment 3111 and a second segment 3112 may be formed in the first frame 310 at a predetermined interval therebetween. The first and second segments 3111 and 3112 may be formed of an empty space or a non-conductive material. The first segment 3111 may be located on the right side of the first frame 310 when viewed from the front plate (e.g., the front plate 10 of FIG. 4) in the direction (-z direction) toward the rear cover 60. The second segment 3112 may be located on the left side of the first frame 310 when viewed from the front plate 10 in the direction (-z direction) toward the rear cover 60. The first segment 3111 may have a width of 11 in x-axis direction. The second segment 3112 may have a width of 12 in the x-axis direction. In addition to the above-described cases, the segments (e.g., the segments 3111, 3112, 3211, 3311 and 3312 of FIG. 3) may be formed in the second frame (e.g., the second frame 320 of FIG. 3), the third frame (e.g., the third frame 330 of FIG. 3), and/or the fourth frame (e.g., the fourth frame 340 of FIG. 3), respectively.

According to the invention, the first conductive tape 600a is attached to cover the DDI 230 mounted by electrical coupling on one surface (e.g., the front direction (+z direction) in FIG. 4) of the FPCB 220. The first conductive tape 600a may include an attachment portion 650a provided to face the DDI 230 to cover a partial region of the electric component on the FPCB 220. The maximum length in y-axis direction of the first conductive tape 600a may be h1. The first conductive tape 600a may be formed to include a protrusion 640a to cover the electric device. Grounding points 630a may be provided at predetermined points of the FPCB 220 and the first conductive tape 600a. The grounding points 630a may include a plurality of grounding points 631a, 633a, 635a and 637a. The plurality of grounding points 631a, 633a, 635a and 637a may be electrical passages through which an electrical signal flowing on the FPCB 220 or the first conductive tape 600a is caused to flow to the ground area 670.

According to the invention, the first conductive tape 600a includes one or more slits 610a and 620a (e.g., the slits 610a and 620a of FIG. 4). The slits 610a and 620a may be empty spaces provided in the first conductive tape 600a. The slits 610a and 620a may include a first slit 610a and/or a second slit 620a. The first slit 610a may be located on the right side of the first frame 310 when viewed from the front plate 10 in a direction (e.g., -z direction) toward the rear cover 60. The second slit 620a may be located on the left side of the first frame 310 when viewed from the front plate 10 in the direction (e.g., -z direction) toward the rear cover 60. The first slit 610a may have a width of w11 in x-axis direction and a depth of d11 in y-axis direction. The second slit 620a may have a width of w12 in x-axis direction and a depth of d12 in y-axis direction. The width w11 of the first slit 610a may be, for example, equal to or longer than the width 11 of the first segment 3111. The width w12 of the second slit 620a may be, for example, equal to or longer than the width 12 of the second segment 3112. The width w11 and/or the width w12 may be approximately 0.1 mm to 4.0 mm, in particular approximately 0.5 mm to 2.0 mm, particularly preferred approximately 1.0 mm to 1.5 mm or approximately 1.25 mm. The depth d11 and/or depth d12 may be equal to or longer than the width w11 and/or the width w12. The depth d11 and/or depth d12 may be approximately 0.5 mm to 6.0 mm, in particular approximately 1.0 mm to 4.0 mm, particularly preferred approximately 1.5 mm to 2.5 mm or approximately 2.0 mm. As the depth d11 and/or the depth d12 increases, it is possible to improve deterioration in antenna performance. However, as the depth d11 and/or the depth d12 increase, when the slits 610a, 620a may be formed in an area adjacent to lcd display unit (LDU), noise may occur due to electrical signal interference. The slits 610a and 620a may be arranged to be aligned with the segments 3111 and 3112 provided in the first frame 310, thereby improving deterioration in antenna performance due to attenuation of the electrical signal radiated from the antenna.

According to an embodiment, the first conductive tape 600a may include a protrusion 640a. The protrusion 640a may be provided to cover other electronic components disposed on the FPCB 220 other than the DDI 230. The protrusion 640a may be provided to cover electronic components disposed on the PCB 40. The protrusion 640a may be disposed in the vicinity of an upper edge of the first conductive tape 600a, for example. The protrusion 640a may be disposed to cover, for example, a connector portion to electrically connect the PCB (e.g., the PCB 40 of FIG. 4). The protrusion 640a may be disposed, for example, to cover the electronic components on the FPCB 220 that may generate an electrical signal that may affect other electronic components, or may be affected by an electrical signal generated by other electronic components. The protrusion 640a may be disposed, for example, to cover the electronic components on the PCB 40 that may generate an electrical signal that may affect other electronic components, or may be affected by an electrical signal generated by other electronic components.

FIG. 5B is a plan view of a structure in which the electronic device (e.g., the electronic device 101 of FIG. 1) has one slit of a first conductive tape (e.g., the first conductive tape 600a of FIG. 4), according to an embodiment of the disclosure.

Hereinafter, since the arrangement and structure of the components in FIG. 5B is substantially the same as that of FIG. 5A, description will be mainly made of their differences. The first conductive tape 601a illustrated in FIG. 5B differs from the first conductive tape 600a illustrated in FIG. 5A in the number of slits included therein. According to an embodiment, the first conductive tape 600a illustrated in FIG. 5A includes two slits 610a and 620a, but the first conductive tape 601a illustrated in FIG. 5B has a single slit 611a.

According to an embodiment, the first conductive tape 601a forms a slit 611a (e.g. corresponding to the first slit 610a of Fig. 5A). The slit 611a may be an empty space provided in the first conductive tape 601a. The slit 611a may have a width w11 in x-axis direction and a depth d11 in y-axis direction. The width w11 of the slit 611a may be, for example, longer than the width 11 of the first segment 3111. As the slit 611a is arranged to be aligned with the first segment 3111 provided in the first frame 310, it is possible to prevent or at least alleviate deterioration in antenna performance due to attenuation of the electrical signal radiated from the antenna.

According to an embodiment, the first conductive tape 601a may include a protrusion 640a. The protrusion 640a may be provided to cover other electronic components disposed on the FPCB 220 other than the DDI 230. The protrusion 640a may be provided to cover electronic components disposed on the PCB 40. The protrusion 640a may be disposed, for example, in the vicinity of an upper edge of the first conductive tape 601a. The protrusion 640a may be disposed, for example, to cover a connector portion that electrically connects a PCB (e.g., the PCB 40 of FIG. 4). The protrusion 640a may be arranged, for example, to cover electronic components on the FPCB 220 that may generate an electrical signal that may affect other electronic components, or may be affected by an electrical signal generated by the other electronic components. Further, the protrusion 640a may be arranged, for example, to cover electronic components on the PCB 40 that may generate an electrical signal that may affect other electronic components, or may be affected by an electrical signal generated by the other electronic components.

In addition to the cases described with reference to this drawing, the slit 611a may be arranged in alignment with another segment (e.g., the second segment 3112 of FIG. 5A) located in the first frame 310. In such a case, the width w11 of the slit 611a may be equal to or longer than the width 12 of the second segment 3112. As the slit 611a may be arranged in alignment with the second segment 3112 provided in the first frame 310, it is possible to improve deterioration in antenna performance due to attenuation of the electrical signal radiated from the antenna.

FIG. 6 is a side cross-sectional view and its partial perspective view illustrating a noise blocking structure in an electronic device (e.g., the electronic device 101 of FIG. 4) according to an embodiment of the disclosure.

Referring to FIG. 6, in an embodiment, the display 210 (e.g., the display 210 of FIG. 4) may have a conductive layer 70 (e.g., the conductive layer 70 of FIG. 4) attached on its lower surface. The conductive layer 70 may serve to block noise (e.g., flickering) generated in the display 210. The conductive layer 70 may be made of metal or graphite. The display 210 may be electrically connected to the FPCB 220 (e.g., the FPCB 220 of FIG. 4). One side of the FPCB 220 may be electrically connected to one side of the display 210. The FPCB 220 may be attached to a thin film material having flexibility on one side thereof to be electrically connected to one side of the display 210.

The first conductive tape 600a (e.g., the first conductive tape 600a of FIG. 4) is formed to cover the DDI 230 (e.g., the DDI 230 of FIG. 4) and/or the FPCB 220 (e.g., the FPCB 220 of FIG. 4). In this case, the first conductive tape 600a may form an electrical path up to the ground area 670, as it is electrically connected to the plurality of grounding points 630a formed on the FPCB 220. The DDI 230 may be attached to the front surface of the FPCB 220, for example. The first conductive tape 600a may cover the FPCB 220 on which the DDI 230 is mounted. The first conductive tape 600a may have a length h1. The length h1 may correspond to a maximum length in y-axis direction of the first conductive tape 600a.

According to an embodiment, the first conductive tape 600a may be electrically coupled to the grounding point 630a (e.g., the grounding points 631a, 633a, 635a and 637a of FIG. 5a) provided in the FPCB 220. The grounding point 630a provided in the FPCB 220 may be electrically connected to the ground area 670. The FPCB 220 may be provided with a via hole 660 for connecting the grounding point 630a to the ground area 670. In this case, the via hole 660 may be filled with a conductive material, or an inner surface thereof may be made of a conductive material. The conductive material in the via hole 660 may serve as a passage for electrically connecting the grounding point 630a and the ground area 670.

According to the invention, segments (e.g., the first, second, third, fourth, or fifth segment 3111, 3112, 3211, 3311 or 3312 of FIG. 3) are formed in the frame 30 (e.g., the frame 30 of FIG. 3). The segments (e.g., the first and second segments 3111 and 3112) disposed in the same frame (e.g., the first frame 310) amongst a plurality of segments 3111, 3112, 3211, 3311 and 3312 may be arranged to be spaced apart by a predetermined interval on the frame. The segments may be made of an empty space or a non-conductive material.

According to an embodiment, a portion B of FIG. 6 is a perspective view illustrating the structure in which the segment (e.g., the first segment 3111) disposed on the frame is arranged in alignment with the slit (e.g., the first slit 610a) of the first conductive tape 600a, thereby achieving improved antenna performance.

According to an embodiment, the segment 3111 (e.g., the first segment 3111 of FIG. 4) may be arranged to be aligned on an axis (e.g., y-axis) perpendicular to the slit 610a of the conductive tape 600a. A horizontal width (e.g., x-axis) of the segment 3111 may have a length 11. A horizontal width (e.g., x-axis) of the slit 610a may have a width w11. The horizontal width w11 of the slit 610a may be equal to or longer than the horizontal width 11 of the segment 3111. As a result of such alignment of the slit 610a and the segment 3111, it is possible to improve deterioration in antenna performance due to attenuation of energy E radiated from the antenna. The number of segments may be equal to or greater than the number of slits.

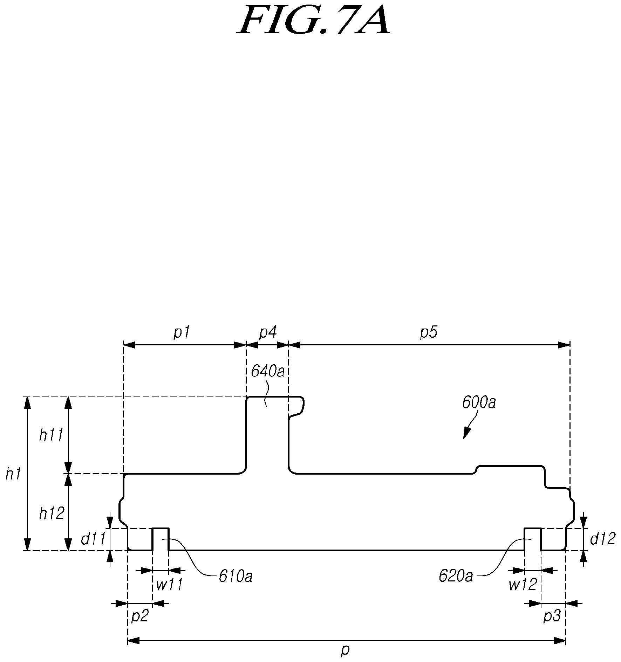

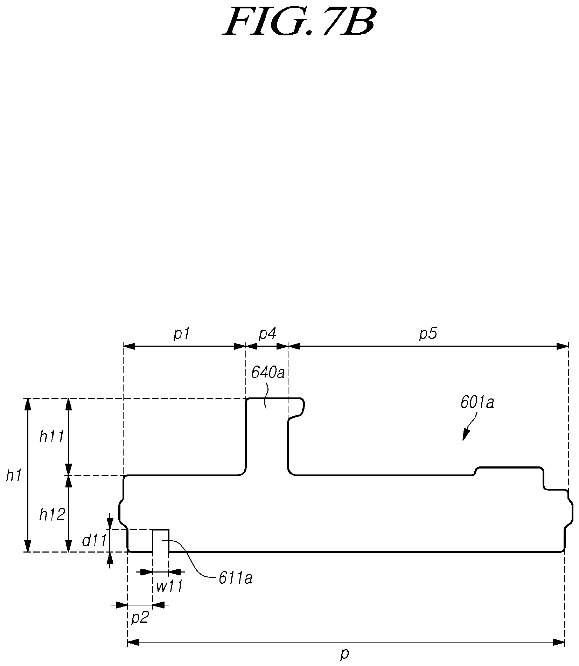

FIGS. 7A and 7B are a top view of the conductive tape (e.g., the first conductive tape 600a of FIG. 5A or the conductive tape 601a of FIG. 5B) applied to the electronic device (e.g., the electronic device 101 of FIG. 4), according to an embodiment of the disclosure. FIG. 7A shows the structure of the first conductive tape 600a provided with two slits (e.g., the first slit 610a or the second slit 620a of FIG. 5A), and FIG. 7B shows the structure of the first conductive tape 601a provided with one slit (e.g., the slit 611a of FIG. 5B).

Referring to FIGS. 7A and 7B, in an embodiment, the first conductive tapes 600a and 601a may have a horizontal length of p (p1 + p4 + p5) and a longitudinal length of h1 (h11 + h12). The horizontal length may be a value corresponding to the width of the first conductive tapes 600a and 601a, and the longitudinal length may be a value corresponding to the height of the first conductive tapes 600a and 601a. The horizontal length may be, for example, a length in the horizontal direction (e.g., x-axis direction of FIG. 4) in the electronic device 101. And the longitudinal length may be, for example, a length in the longitudinal direction (e.g., y-axis direction of FIG. 4) in the electronic device 101.

According to an embodiment, the first conductive tape 600a may include a plurality of slits. The first conductive tape 600a may include, for example, a first slit 610a and a second slit 620a. The first slit 610a and/or the second slit 620a may be formed as an empty space in which a predetermined area is cut out from the first conductive tape 600a. The first slit 610a may be formed to have a predetermined width and a predetermined depth at a point spaced apart by a distance p2 from a lower left edge of the first conductive tape 600a. The first slit 610a may be formed to have a width w11 in a horizontal direction (e.g., x-axis direction of FIG. 4) and a depth d11 in a vertical direction (e.g., y-axis direction of FIG. 4), for example. The second slit 620a may be formed to have a predetermined width and a predetermined depth at a point spaced apart by a distance p3 away from a lower right edge of the first conductive tape 600a. The second slit 620a may have a width w12 in the horizontal direction (e.g., x-axis direction of FIG. 4) and a depth d12 in the vertical direction (e.g., y-axis direction of FIG. 4), for example. The width values w11 and w12 may be substantially the same as or different from each other. The depth values d11 and d12 may be substantially the same as or different from each other. For example, the width values w11 and/or w12 may be equal to or smaller than one or both of the values of the distances p2 and p3. In another embodiment, the width values w11 and/or w12 may be longer than one or both of the values of the distances p2 and p3.

According to an embodiment, the first conductive tape 601a may include one slit. The first conductive tape 601a may include, for example, a slit 611a. The slit 611a may be formed as an empty space in which a predetermined area is cut out from the first conductive tape 601a. The slit 611a may be formed to have a predetermined width and a predetermined depth at a point spaced apart by a distance p2 from the lower left edge of the first conductive tape 601a. The slit 611a may be formed to have a width w11 in the horizontal direction (e.g., x-axis direction of FIG. 4) and a depth d11 in the vertical direction (e.g., y-axis direction of FIG. 4), for example. For example, the width value w11 may be equal to or smaller than the value of the distance p2. In another embodiment, the width value w11 may be longer than the value of the distance p2.

According to an embodiment, the first conductive tapes 600a and 601a may include an area (e.g., the attachment part 650a of FIG. 4) that can cover the DDI (e.g., the DDI 230 of FIG. 5A or FIG. 5B). The first conductive tapes 600a and 601a may further include an area that can cover some of electrical components disposed on a PCB (e.g., the PCB 40 of FIG. 4) or an FPCB (e.g., the FPCB 220 of FIG. 4). According to an embodiment, the electrical components that can be covered by the first conductive tapes 600a and 601a, being disposed on a substrate or the FPCB 220 of a display panel (not shown) included in the display 210, may be an electronic component capable of emitting an electrical signal such as radio waves to the outside.

According to an embodiment, the first conductive tapes 600a and 601a may include a protrusion 640a. The protrusion 640a may be provided to cover other electronic components disposed on the FPCB 220 other than the DDI 230.

The protrusion 640a may be provided to cover electronic components disposed on the PCB 40. The protrusion 640a may be disposed, for example, in the vicinity of an upper edge of the first conductive tapes 600a and 601a. The protrusion 640a may be disposed to cover, for example, the connector portion that electrically connects the PCB (e.g., the PCB 40 of FIG. 4). The protrusion 640a may be arranged, for example, to cover electronic components on the FPCB 220 that may generate an electrical signal that may affect other electronic components, or may be affected by an electrical signal generated by the other electronic components. Further, the protrusion 640a may be arranged, for example, to cover electronic components on the PCB 40 that may generate an electrical signal that may affect other electronic components, or may be affected by an electrical signal generated by the other electronic components.

According to an embodiment, the protrusion 640a may be formed to have a predetermined width and a predetermined depth. The protrusion 640a may, for example, have a width p4 in the horizontal direction (e.g., x-axis direction of FIG. 4) and a height h11 in the vertical direction (e.g., y-axis direction of FIG. 4). For example, the protrusion 640a may be arranged in between a position away by a distance p1 from a vicinity of the upper left edge of the first conductive tapes 600a and 601a and a position away by a distance p5 from a vicinity of the upper right edge of the first conductive tapes 600a and 601a, so that it has at least a width greater than or equal to p4 and a height of h11. The value p4 indicative of the width or the value h11 indicative of the height of the protrusion 640a may be determined based on a position in which an electric element to be covered with the first conductive tapes 600a and 601a is arranged. For example, a value of the distance p1 may be equal to or smaller than a value of the distance p5. In another embodiment, the value of the distance p1 may be longer than the value of the distance p5. A value of the width p4 may be smaller than the value of the distance p1 and/or distance p5.

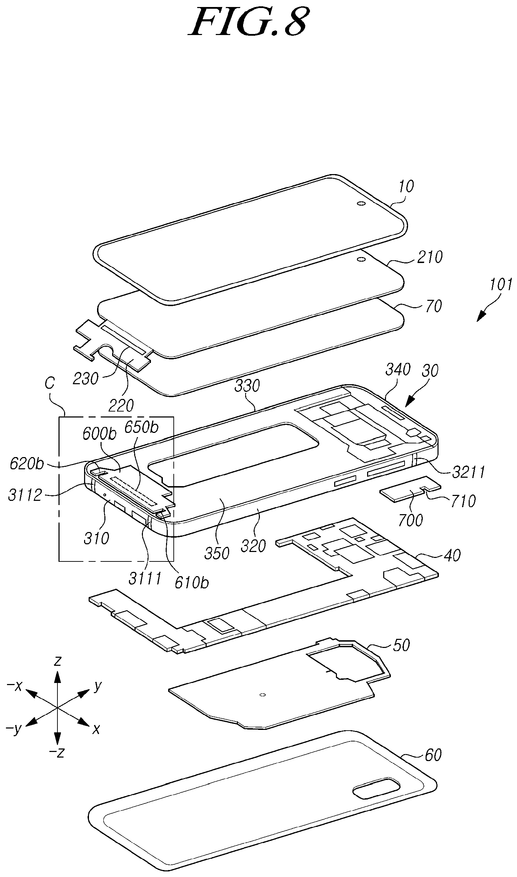

FIG. 8 is an exploded perspective view of an electronic device (e.g., the electronic device 101 of FIG. 1) according to an embodiment.

The components shown in FIG. 8 and the arrangement relationship between those components may be described as in FIG. 4. Hereinafter, description will be mainly made based on their differences from FIG. 4. The exploded perspective view of the electronic device 101 shown in FIG. 8 illustrates the same components as in the exploded perspective view of the electronic device 101 shown in FIG. 4, but a position in which the conductive tape 600b provided to shield between the DDI 230 and the segments 3111 and 3112 is arranged may be different from each other. According to an embodiment, it is suggested in FIG. 4 that the conductive tape (e.g., the first conductive tape 600a) is attached to the FPCB (e.g., the FPCB 220 of FIG. 4), but it is suggested in FIG. 8 that the second conductive tape 600b is attached to a bracket 350 (e.g., the bracket 350 of FIG. 4).

Referring to FIG. 8, the electronic device 101 according to an embodiment may include a second conductive tape 600b. The second conductive tape 600b may be defined as a conductive tape attached to a front surface of the bracket 350. When the display 210 is coupled to the frame 30 so that the FPCB 220 is electrically connected to the PCB 40, the DDI 230 mounted on the FPCB 220 may be positioned to face an attachment portion 650b provided on the second conductive tape 600b attached to the bracket 350.

According to an embodiment, the second conductive tape 600b may form one or more slits 610b and 620b. The slits 610b and 620b may be empty spaces provided in the second conductive tape 600b. The slits 610b and 620b may include a first slit 610b and a second slit 620b. The first slit 610b may correspond to a slit located on the right side of the first frame 310 when viewed from the front plate 10 in a direction (e.g., -z direction) of the rear cover 60. The second slit 620b may correspond to a slit located on the left side of the first frame 310 when viewed from the front plate 10 in the direction (e.g., -z direction) of the rear cover 60.

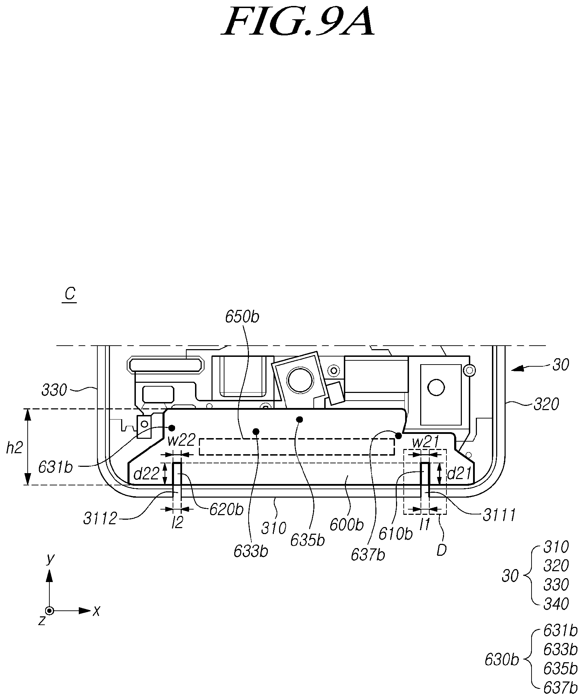

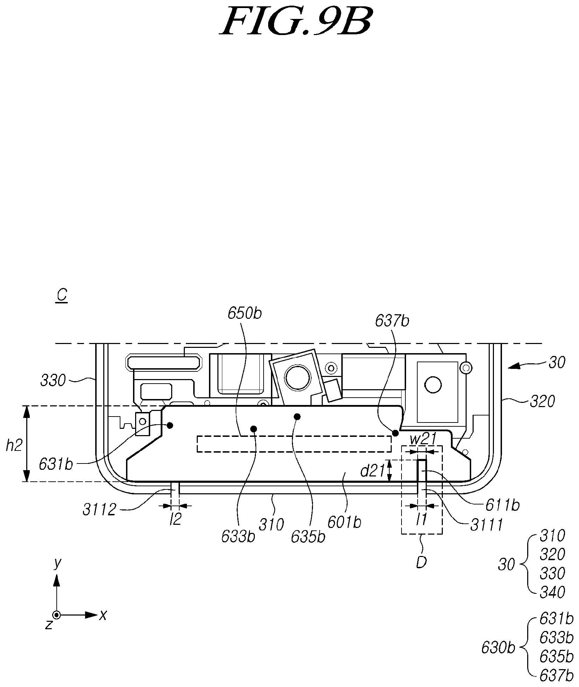

FIGS. 9A and 9B are partial plan views of a structure in which a conductive tape (e.g., the second conductive tape 600b of FIG. 8) is attached to a bracket (e.g., the bracket 350 of FIG. 8) in the electronic device (e.g., the electronic device 101 of FIG. 1) according to an embodiment of the disclosure. In other words, it illustrates a plan view of a part C in FIG. 8.

Referring to FIG. 9A, a first segment 3111 and a second segment 3112 may be formed in the first frame 310 with a predetermined interval therebetween. The first and second segments 3111 and 3112 may be formed of an empty space or a non-conductive material. The first segment 3111 may be located on the right side of the first frame 310 when viewed from the front plate 10 in the direction (e.g., -z direction) of the rear cover 60. The second segment 3112 may be located on the left side of the first frame 310 when viewed from the front plate 10 in the direction (e.g., -z direction) of the rear cover 60. The first segment 3111 may have a width 11 in x-axis direction. The second segment 3112 may have a width 12 in x-axis direction. In addition to the above-described, the segments (e.g., the third, fourth and fifth segments 3211, 3311 and 3312) may be formed in the second frame (e.g., the second frame 320 of FIG. 3), the third frame (e.g., the third frame 330 of FIG. 3), and/or the fourth frame (e.g., the fourth frame 340 of FIG. 3).

According to an embodiment, the second conductive tape 600b may be attached to one surface (e.g., in the front direction (+z direction) of FIG. 8). The second conductive tape 600b may cover a partial area of an electric component on the FPCB 220, including the area 650b to which the DDI 230 is attached. A maximum length of the second conductive tape 600b in the y-axis direction may be h2. A grounding point 630b may be provided at a predetermined point of the second conductive tape 600b. The grounding point 630b may include a plurality of grounding points 631b, 633b, 635b and 637b. The grounding point 630b may be arranged at a predetermined point between the FPCB 220 and the second conductive tape 600b. The grounding point 630b may include a plurality of grounding points 631b, 633b, 635b and 637b. The plurality of grounding points 631b, 633b, 635b and 637b may be a passage to cause an electrical signal flowing on the FPCB 220 or the second conductive tape 600b to flow into a ground area (e.g., the ground area 670 of FIG. 6).

According to an embodiment, the second conductive tape 600b may form one or more slits 610b and 620b (e.g., the slits 610b and 620b of FIG. 8). The slits 610b and 620b may be empty spaces provided in the second conductive tape 600b. The slits 610b and 620b may include a first slit 610b and a second slit 620b. The first slit 610b may be located on the right side of the first frame 310 when viewed from the front plate 10 in a direction (e.g., -z direction) of the rear cover 60. The second slit 620b may be located on the left side of the first frame 310 when viewed from the front plate 10 in a direction (e.g., -z direction) of the rear cover 60. The first slit 610b may have a width w21 in the x-axis direction and a depth d21 in the y-axis direction. The second slit 620b may have a width w22 in the x-axis direction and a depth d22 in the y-axis direction. The width w21 of the first slit 610b may be equal to or longer than the width 11 of the first segment 3111. The width w22 of the second slit 620b may be equal to or longer than the width 12 of the second segment 3112. According to an embodiment, the first and second slits 610b and 620b may analogously include the features as described in the light of the first and second slits 610a and 620a(e.g. slits 610a and 620a in FIG. 4). The slits 610a and 620a may be arranged to be aligned with the segments 3111 and 3112 provided in the first frame 310, thereby improving deterioration in antenna performance due to attenuation of an electrical signal radiated from the antenna.

FIG. 9B is a plan view illustrating a structure in which the second conductive tape (e.g., the second conductive tape 600b of FIG. 8) has one slit in the electronic device (e.g., the electronic device 101 of FIG. 1) according to an embodiment.

The arrangement and structure between the components in FIG. 9B is substantially the same as that of FIG. 9A, so description will be mainly made based on their differences hereinafter.

Referring to FIG. 9B, the second conductive tape 601b may form a slit 611b. The slit 611b may be an empty space provided in the second conductive tape 601b. The slit 611b may have a width w21 in the x-axis direction and a depth d21 in the y-axis direction. The width w21 of the slit 611b may be equal to or longer than the width 11 of the first segment 3111. According to an embodiment, the slit 611b may analogously include the features as described in the light of the slit 611a(e.g. slit 611a in FIG. 9A). The slit 611b may be arranged to be aligned with the segment 3111 provided in the first frame 310, thereby improving deterioration in antenna performance due to attenuation of an electrical signal radiated from the antenna.

In addition to the cases described above with reference to this drawing, the slit 611b may be arranged in alignment with another segment (e.g., the second segment unit 3112) positioned in the first frame 310. In this case, the width w21 of the slit 611b may be equal to or longer than the width 12 of the second segment 3112. As the slit 611b is arranged to be aligned with the second segment 3112 provided in the first frame 310, it is possible to improve deterioration in antenna performance due to attenuation of an electrical signal radiated from the antenna.

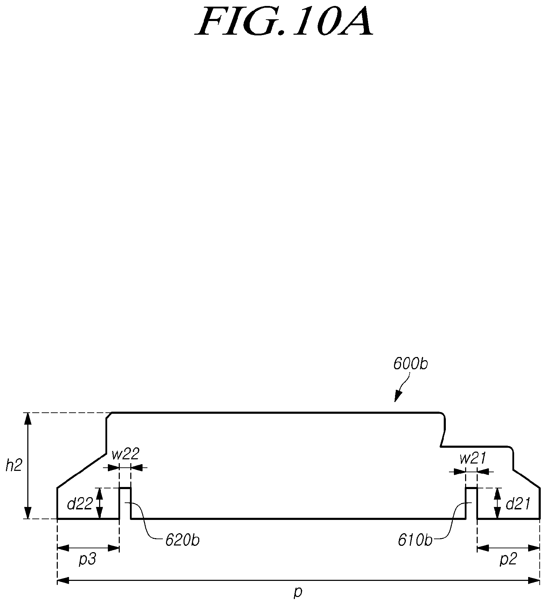

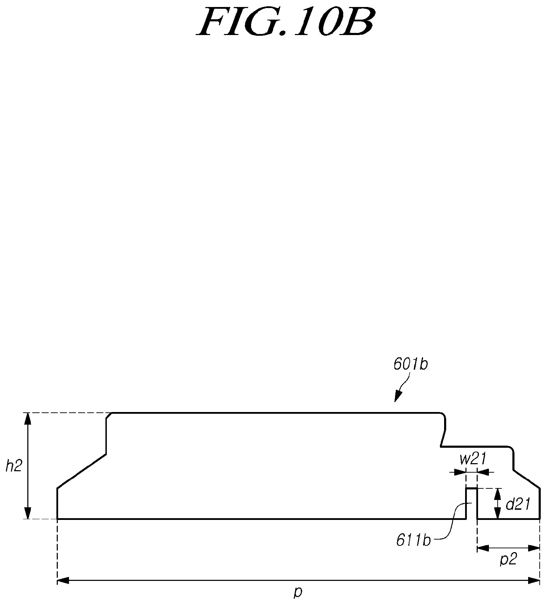

FIGS. 10A and 10B are plan views of a conductive tape (e.g., the second conductive tape 600b of FIG. 8) applied to an electronic device (e.g., the electronic device 101 of FIG. 8), according to an embodiment of the disclosure.

Referring to FIGS. 10A and 10B, the second conductive tapes 600b and 601b may have a horizontal length p and a vertical length h2. The horizontal length may correspond to the width of the second conductive tapes 600b and 601b, and the vertical length may correspond to the height of the second conductive tapes 600b and 601b. The horizontal length may be, for example, a length in the horizontal direction (e.g., the x-axis direction of FIG. 8) in the electronic device 101. The vertical length may be, for example, the length in the vertical direction (e.g., the y-axis direction of FIG. 8) in the electronic device 101.

Referring to FIG. 10A, the second conductive tape 600b may include a plurality of slits. The second conductive tape 600b may include, for example, a first slit 610b and/or a second slit 620b. The first slit 610b and/or the second slit 620b may be formed as an empty space in which a predetermined area is cut out from the first conductive tape 600b. The first slit 610b may be formed to have a predetermined width and a predetermined depth at a point away by a distance p2 from the vicinity of the lower right edge of the first conductive tape 600b. The first slit 610b may have a width w21 in the horizontal direction (e.g., the x-axis direction of FIG. 8) and a depth d21 in the vertical direction (e.g., the y-axis direction of FIG. 8), for example. The second slit 620b may be formed to have a predetermined width and a predetermined depth at a point p3 away by a distance p3 from the vicinity of the lower left edge of the second conductive tape 600b. The second slit 620b may have the width w22 in the horizontal direction (e.g., the x-axis direction of FIG. 8) and the depth of d22 in the vertical direction (e.g., the y-axis direction of FIG. 8), for example. The width w21 and the width w22 may be the same as or different from each other. Further, the depth d21 and the depth d22 may be the same as or different from each other. According to an embodiment, the first and second slits 610b and 620b may analogously include the features as described in the light of the first and seconds slits 610a and 620a(e.g. slits 610a and 620a in FIG. 4).

Referring to FIG. 10B, the second conductive tape 601b may include one slit. The second conductive tape 601b may include, for example, a slit 611b. The slit 611b may be formed as an empty space in which a predetermined area is cut out from the second conductive tape 601b. The slit 611b may be formed to have a predetermined width and a predetermined depth at a point away by a distance p2 from the lower right edge of the second conductive tape 601b.

The slit 611b may have a width w21 in the horizontal direction (e.g., the x-axis direction of FIG. 8) and a depth d21 in the vertical direction (e.g., the y-axis direction of FIG. 4), for example. According to an embodiment, the slit 611b may analogously include the features as described in the light of the slit 611a(e.g. slits 611a in FIG. 9A).

According to an embodiment, the second conductive tapes 600b and 601b may include an area (e.g., the area 650b of FIG. 8) that can cover the DDI (e.g., the DDI 230 of FIG. 8). The second conductive tapes 600b and 601b may further include an area capable of covering some of the electrical components disposed on the FPCB (e.g., the FPCB 220 of FIG. 8). According to an embodiment, the electrical component that is disposed on a substrate or an FPCB (e.g., the FPCB 220 of FIG. 8) of a display panel (not shown) included in the display 210 to be covered by the second conductive tapes 600b and 601b may be, for example, an electronic component capable of emitting an electrical signal such as radio waves to the outside.

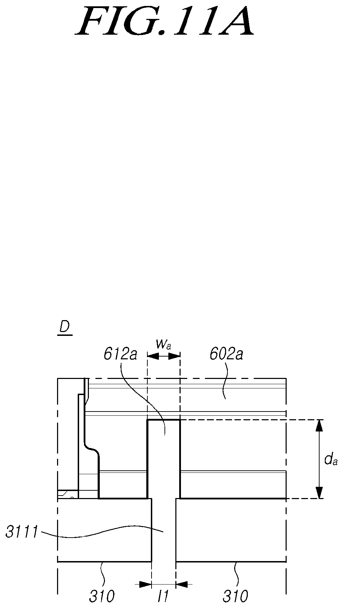

FIGS. 11A to 11F are partial plan views each illustrating a shape of the slit provided in the conductive tape (e.g., the first conductive tapes 600a and 601a of FIGS. 5A and 5B or the second conductive tapes 600b and 601b of FIGS. 9A and 9B) applied to the electronic device (e.g., the electronic device 101 of FIG. 1) according to an embodiment. In other words, FIGS. 11A to 11F are enlarged views of a part D indicated by a dotted line in FIGS. 5A, 5B, 9A or 9B.

The slits 612a, 612b, 612c, 612d, 612e and 612f provided in the conductive tape shown in FIGS. 11A to 11F may correspond to the first slits 610a and 610b and/or the second slits 620a in FIGS. 5A or 9A and/or correspond to the slits 611a and 611b in FIG. 5B or FIG. 9B.

Referring to FIG. 11A, according to an embodiment, the segment 3111 (e.g., the first segment 3111 of FIG. 3) may be formed in the frame 310 (e.g., the first frame 310 of FIG. 3). The segment 3111 may be formed as an empty space or may be filled with a non-conductive material. The segment 3111 may have a predetermined width 11 in the horizontal direction (e.g., the x-axis direction of FIG. 4) and a predetermined thickness in the vertical direction (e.g., the y-axis direction of FIG. 4) of the frame 310.

According to an embodiment, one or more slits may be formed by removing a portion of a conductive tape 602a (e.g., the first conductive tape 600a of FIG. 4 or the second conductive tape 600b of FIG. 8). The conductive tape 602a may include, for example, a slit 612a. The slit 612a may have an angular shape, e.g. a quadrangular shape with four sides, such as a square or a rectangle. The slit 612a may have a width $w_a$ in the horizontal direction (e.g., the x-axis direction of FIG. 4 or FIG. 8), and a depth $d_a$ in the vertical direction (e.g., the y-axis direction of FIG. 4 or FIG. 8). The width $w_a$ and the depth $d_a$ may have a relationship such as $w_a \leq d_a$.

According to an embodiment, the slit 612a may be arranged in alignment with the segment 3111 on the vertical axis (e.g., the y-axis of FIG. 4 or FIG. 8). In other words, the centers of the slit 612a and the segment 3111 along the vertical axis may correspond to each other. The slit 612a may have, for example, a predetermined area at one end (a lower end of the slit) facing the inner surface of the at least one segment 3111. The width $w_a$ of the slit 612a may be equal to or greater than, in particular at least 10 percent, particularly preferred at least 25 percent greater than, the width 11 of the segment 3111. The left end of the slit 612a may be located on the same line as the left end of the segment 3111 with respect to the horizontal direction or may be located to the left of the left end of the segment 3111. The right end of the slit 612a may be located on the same line as the right end of the segmented part 3111 with respect to the horizontal direction, or may be located to the right of the right end of the segment 3111.

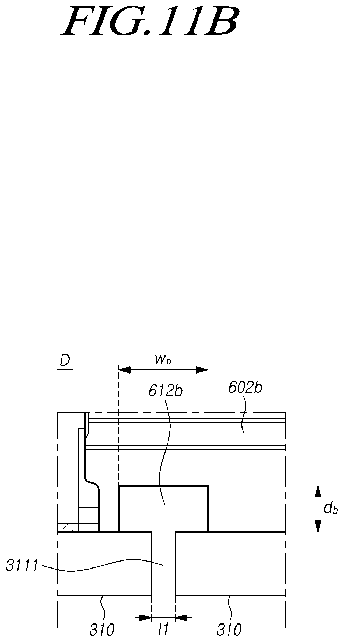

Referring to FIG. 11B, according to an embodiment, a segment 3111 (e.g., the first segment 3111 of FIG. 3) may be formed in the frame 310 (e.g., the first frame 310 of FIG. 3). The segment 3111 may be formed as an empty space or may be filled with a non-conductive material. The segment 3111 may have a predetermined width 11 in the horizontal direction (e.g., the x-axis direction of FIG. 4 or FIG. 8) and a predetermined thickness in the vertical direction (e.g., the y-axis direction of FIG. 4 or FIG. 8) of the frame 310.

According to an embodiment, one or more slits may be formed by removing a portion of a conductive tape 602b (e.g., the first conductive tape 600a of FIG. 4 or the second conductive tape 600b of FIG. 8). The conductive tape 602b may include, for example, a slit 612b. The slit 612b may have an angular shape, e.g. a quadrangular shape with four sides, such as e.g., a square or a rectangle. The slit 612b may have a width $w_b$ in the horizontal direction and a depth $d_b$ in the vertical direction. The width $w_b$ and the depth $d_b$ may have a relationship such as $d_b \leq w_b$.

According to an embodiment, the slit 612b may be aligned with the segment 3111 on the vertical axis (e.g., the y-axis of FIG. 4 or FIG. 8). In other words, the centers of the slit 612b and the segment 3111 along the vertical axis may correspond to each other. The slit 612b may have, for example, a predetermined area at one end (a lower end of the slit) facing the inner surface of the at least one segment 3111. The width $w_b$ of the slit 612b may be equal to or greater than, in particular at least 100 percent, particularly preferred at least 200 percent greater than, the width 11 of the segment 3111. The left end of the slit 612b may be located on the same line as the left end of the segment 3111 with respect to the horizontal direction or may be located to the left of the left end of the segment 3111. The right end of the slit 612b may be located on the same line as the right end of the segment 3111 with respect to the horizontal direction or may be located to the right of the right end of the segment 3111.

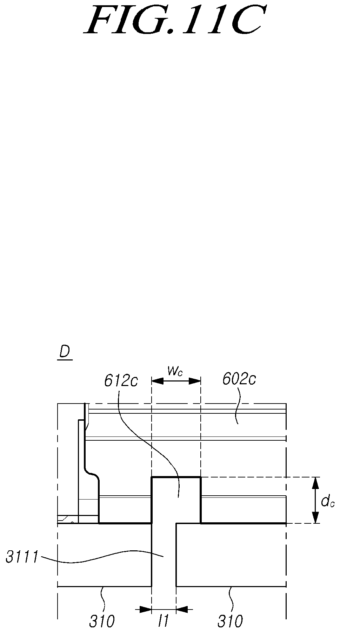

Referring to FIG. 11C, according to an embodiment, the segment 3111 (e.g., the first segment 3111 of FIG. 3) may be formed in the frame 310 (e.g., the first frame 310 of FIG. 3). The segment 3111 may be formed as an empty space or may be filled with a non-conductive material. The segment 3111 may have a predetermined width 11 in the horizontal direction (e.g., the x-axis direction of FIG. 4 or FIG. 8) and a predetermined thickness in the vertical direction (e.g., the y-axis direction of FIG. 4 or 8) of the frame 310.

According to an embodiment, one or more slits may be formed by removing a portion of a conductive tape 602c (e.g., the first conductive tape 600a of FIG. 4 or the second conductive tape 600b of FIG. 8). The conductive tape 602c may include, for example, a slit 612c. The slit 612c may have an angular shape, e.g. a quadrangular shape with four sides, such as e.g., a square or a rectangle. The slit 612c may have a width $w_c$ in the horizontal direction (e.g., the x-axis direction of FIG. 4 or FIG. 8) and a depth $d_c$ in the vertical direction (e.g., the y-axis direction of FIG. 4 or FIG. 8).

According to an embodiment, the slit 612c may be arranged in alignment with the segment 3111 on the vertical axis. The slit 612c may have, for example, a predetermined area at one end (a lower end of the slit) facing the inner surface of the at least one segment 3111. The width $w_c$ of the slit 612c may be equal to or greater than, in particular at least 50 percent, particularly preferred at least 100 percent greater than, the width 11 of the segment 3111. The left end of the slit 612c may be positioned on substantially the same line as the left end of the segment 3111 with respect to the horizontal direction or may be positioned to the left of the left end of the segment 3111. The right end of the slit 612c may be located on substantially the same line as the right end of the segment 3111 with respect to the horizontal direction or may be located to the right of the right end of the segment 3111.

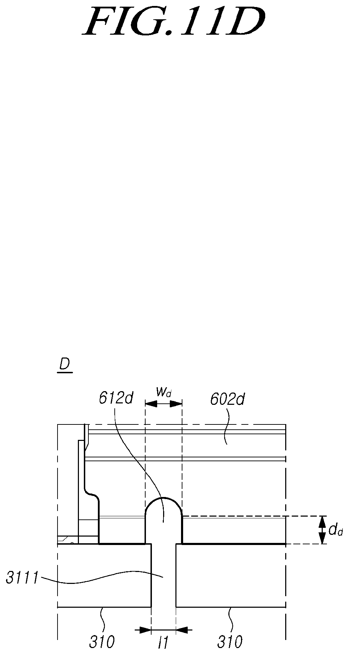

Referring to FIG. 11D, according to an embodiment, the segment 3111 (e.g., the first segment 3111 of FIG. 3) may be formed in the frame 310 (e.g., the first frame 310 of FIG. 3). The segment 3111 may be formed as an empty space or may be filled with a non-conductive material. The segment 3111 may have a predetermined width 11 in the horizontal direction (e.g., the x-axis direction of FIG. 4 or FIG. 8) and a predetermined thickness in the vertical direction (e.g., the y-axis direction of FIG. 4 or 8) of the frame 310.

According to an embodiment, one or more slits may be formed by removing a portion of a conductive tape 602d (e.g., the first conductive tape 600a of FIG. 4 or the second conductive tape 600b of FIG. 8). The conductive tape 602d may include, for example, a slit 612d. The slit 612d may have a round shape, e.g. a shape in which an upper end of a quadrangle is curved, such as e.g., an arch. The slit 612d may have a width $w_d$ in the horizontal direction (e.g., the x-axis direction of FIG. 4 or FIG. 8), and a predetermined depth in the vertical direction (e.g., the y-axis direction of FIG. 4 or 8). For example, the predetermined depth may have a length that is greater than $d_d$ and smaller than a height h of the conductive tape 602d (e.g., h1 in FIGS. 5A to 5B or h2 in FIGS. 9A to 9B).

According to an embodiment, the slit 612d may be arranged in alignment with the segment 3111 on the vertical axis. In other words, the centers of the slit 612d and the segment 3111 along the vertical axis may correspond to each other. The slit 612d may have, for example, a predetermined area at one end (a lower end of the slit) facing the inner surface of the at least one segment 3111. The width $w_d$ of the slit 612d may be equal to or greater than, in particular at least 10 percent, particularly preferred at least 25 percent greater than, the width 11 of the segment 3111. The left end of the slit 612d may be located on substantially the same line as the left end of the segment 3111 with respect to the horizontal direction or may be located to the left of the left end of the segment 3111. The right end of the slit 612d may be located on substantially the same line as the right end of the segment 3111 with respect to the horizontal direction or may be located to the right of the right end of the segment 3111.

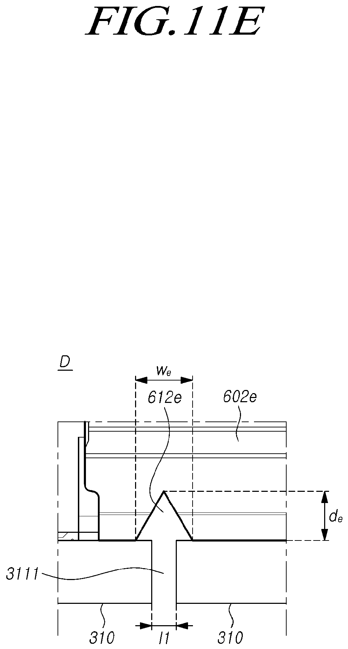

Referring to FIG. 11E, according to an embodiment, the segment 3111 (e.g., the first segment 3111 of FIG. 3) may be formed in the frame 310 (e.g., the first frame 310 of FIG. 3). The segment 3111 may be formed as an empty space or may be filled with a non-conductive material. The segment 3111 may have a predetermined width 11 in the horizontal direction (e.g., the x-axis direction of FIG. 4 or FIG. 8) and a predetermined length thickness in the vertical direction (e.g., the y-axis direction of FIG. 4 or FIG. 8) of the frame 310.

According to an embodiment, one or more slits may be formed by removing a portion of a conductive tape 602e (e.g., the first conductive tape 600a of FIG. 4 or the second conductive tape 600b of FIG. 8). The conductive tape 602e may include, for example, a slit 612e. The slit 612e may have an angular shape, e.g. a triangular shape with three sides, such as e.g., an equilateral triangle or a right-angled triangle. However, the present invention is not limited thereto, and the slit may have a triangular shape in which its width gradually decreases as it goes farther away from the segment 3111. The slit 612e may have a base with a width $w_e$ in the horizontal direction (e.g., the x-axis direction of FIG. 4 or FIG. 8) and sides with a depth $d_e$ in the vertical direction (e.g., the y-axis direction of FIG. 4 or FIG. 8).

According to an embodiment, the slit 612e may be disposed in alignment with the segment 3111 on a vertical axis. In other words, the centers of the slit 612e and the segment 3111 along the vertical axis may correspond to each other. The slit 612e may have, for example, a predetermined area at one end (a lower end of the slit) facing the inner surface of the at least one segment 3111. The length $w_e$ of the base of the slit 612e may be equal to or greater than, in particular at least 25 percent, particularly preferred at least 50 percent greater than, the width 11 of the segment 3111. A lower left vertex of the slit 612e may be located on substantially the same line as the left end of the segment 3111 with respect to the horizontal direction or may be located to the left of the left end of the segment 3111. A lower right vertex of the slit 612e may be located on substantially the same line as the right end of the segment 3111 with respect to the horizontal direction or may be located to the right of the right end of the segment 3111.

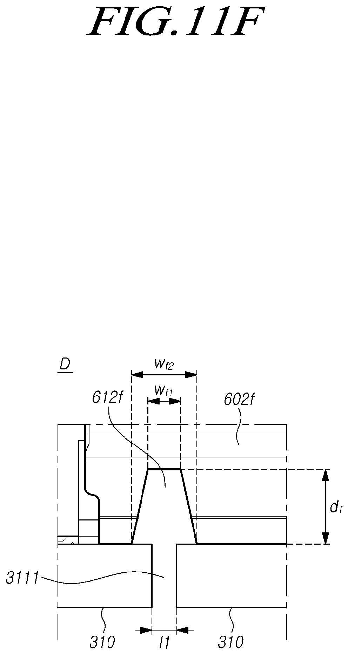

Referring to FIG. 11F, according to an embodiment, the segment 3111 (e.g., the first segment 3111 of FIG. 3) may be formed in the frame 310 (e.g., the first frame 310 of FIG. 3). The segment 3111 may be formed as an empty space or may be filled with a non-conductive material. The segment 3111 may have a predetermined width 11 in the horizontal direction (e.g., the x-axis direction of FIG. 4 or FIG. 8) and a predetermined thickness in the vertical direction (e.g., the y-axis direction of FIG. 4 or 8) of the frame 310.

According to an embodiment, one or more slits may be formed by removing a portion of a conductive tape 602f (e.g., the first conductive tape 600a of FIG. 4 or the second conductive tape 600b of FIG. 8). The conductive tape 602f may include, for example, a slit 612f. The slit 612f may have an angular shape, e.g. a quadrangular shape with four sides, such as e.g., a trapezoid. However, it is not limited to the illustrated trapezoidal shape, and the slit 612f may have a trapezoidal shape in which its width is gradually narrowed as it goes farther away from the segment 3111. The slit 612f may have a bottom side with a length $w_{f2}$ in the horizontal direction (e.g., the x-axis direction of FIG. 4 or FIG. 8), a top side with a length $w_{f1}$ in the horizontal direction (e.g., an x-axis direction), and a depth $d_f$ in the vertical direction (e.g., the y-axis direction of FIG. 4 or FIG. 8). For example, the relationship between the lengths $w_{f1}$ and $w_{f2}$ may correspond to $w_{f2} \geq w_{f1}$.

According to an embodiment, the slit 612f may be arranged in alignment with the segment 3111 on the vertical axis. In other words, the centers of the slit 612f and the segment 3111 along the vertical axis may correspond to each other. The slit 612f may have, for example, a predetermined area at one end (a lower end of the slit) facing the inner surface of the at least one segment 3111. The length $w_{f2}$ of the base of the slit 612f may be equal to or greater than, in particular at least 100 percent, particularly preferred at least 200 percent greater than, the width 11 of the segment 3111. The left end of the slit 612f may be positioned on substantially the same line as the left end of the segment 3111 or may be positioned to the left of the left end of the segment 3111. The right end of the slit 612f may be positioned on substantially the same line as the right end of the segment 3111 or may be positioned to the right of the right end of the segment 3111.

The electronic device according to various embodiments of the present disclosure may be various types of devices. The electronic device may include, for example, a portable communication device (e.g., a smart phone), a computing device, a portable multimedia device, a portable medical device, a camera, a wearable device, or a home appliance device. The electronic device according to various embodiments of the present disclosure is not limited to the above-described devices.

According to an embodiment of the disclosure, an electronic device comprises a display panel 210, a printed circuit board 220, a display driver integrated circuit (DDI) 230, and a shielding tape 600a or 600b covering a metal housing 30. To this end, the electronic device may comprise the DDI 230 electrically coupled to the display panel 210 and the printed circuit board 220, the DDI 230 being configured to control driving of the display panel 210, a frame 30 made of a metal material along an outer rim, and a conductive tape 600a or 600b provided or configured to cover the DDI 230 between the DDI 230 and the frame 30 so as to block a radio signal from being transmitted to the DDI 230. The frame 30 comprises segments 3111 or 3112 made of a non-metallic material in order to transmit and receive the radio signal at a or any position of the outer rim. In other words, the segments may be arranged at an arbitrary position of the outer rim such that the radio signal is transmittable and/or receivable via the one or more segments. The conductive tape 600a or 600b comprises a slit 610a, 620a, 610b, or 620b facing a segment 3111 or 3112 and having a predetermined area. In the electronic device 101 according to an embodiment of the disclosure, the conductive tapes 600a and 600b may be formed in a direction normal to an inner surface of a lower end 310 of the frame. The conductive tapes 600a and 600b may be formed in a direction parallel to the display 210. The conductive tapes 600a and 600b may be grounded.

In the electronic device 101 according to an embodiment of the disclosure, one side of the slits 610a, 620a, 610b and 620b may be provided to face an inner surface of a corresponding segment 3111 or 3112 of the one or more segments 3111 and 3112. A length of one side facing the inner surface of the slits 610a, 620a, 610b and 620b may be greater than or equal to a width of the targeted segments 3111 and 3112. A greater length of one side facing the inner surface of the slits improves the antenna performance by reducing the deterioration generally caused by the conductive tape.

In the electronic device 101 according to an embodiment of the disclosure, the slits 610a, 620a, 610b and 620b may be formed of a non-conductive material. For example, the slits may be formed of an empty space.

In the electronic device 101 according to an embodiment of the disclosure, the number of the segments 3111 and 3112 may be equal to or greater than the number of the slits 610a, 620a, 610b and 620b. Each combination of segment and slit improves the antenna performance by reducing the deterioration generally caused by the conductive tape. In particular, when the numbers of segments and slits are equal the improvement of the antenna performance is particularly efficient.

In the electronic device 101 according to an embodiment of the disclosure, a width of the slits 610a, 620a, 610b and 620b may be configured in a shape that the width is either constant or narrower as it goes away from one end facing the inner surface of one of the one or more segments 3111 and 3112.

In the electronic device 101 according to an embodiment of the disclosure, the slits 610a, 620a, 610b and 620b may have substantially an angular shape, e.g. a triangular shape. As the slits may be of different shapes and sizes, the conductive tapes can be used versatilely.

In the electronic device 101 according to an embodiment of the disclosure, the slits 610a, 620a, 610b and 620b may have substantially an angular shape, e.g. a quadrilateral shape. As the slits may be of different shapes and sizes, the conductive tapes can be used versatilely.

In the electronic device 101 according to an embodiment of the disclosure, the slits 610a, 620a, 610b and 620b may have a round shape, e.g. a semi-circular shape. As the slits may be of different shapes and sizes, the conductive tapes can be used versatilely.

In the electronic device 101 according to an embodiment of the disclosure, a transverse length of one end of the slits 610a, 620a, 610b and 620b facing the inner surface of any one of the one or more segments 3111 and 3112 may be configured to be equal to or greater than a transverse length of the segment.

The electronic device 101 according to an embodiment of the disclosure may be grounded in a specific area of the conductive tapes 600a and 600b.

The electronic device 101 according to an embodiment of the disclosure may further include at least one or more power feeders. The feeder may be electrically coupled to any one of the one or more segments 3111 and 3112.

The slits 610a, 620a, 610b and 620b may have a width that is the same as or wider than that of the segments 3111 and 3112 provided in the metal frame 30. The slits may face the segments provided in the metal frame and may have a predetermined area.

The various embodiments and terms used herein are not intended to limit the technical features described herein to specific embodiments and should be understood to include various modifications, equivalents, or substitutes of the embodiment, provided that said modifications, equivalents, or substitutes fall with the scope of the appended claims. In connection with the description of the drawings, like reference numerals may be used for similar or related components. The singular form of a noun corresponding to an item may include one or more of the item, unless the relevant context clearly dictates otherwise. In this document, each of the phrases such as "A or B", "at least one of A and B", "at least one of A or B", "A, B or C", "at least one of A, B and C", and "at least one of A, B, or C" may include any one of the items enumerated together in a corresponding one of the phrases, or all possible combinations thereof. Terms such as "the first", "the second", or "first", or "second" may be used simply to distinguish a corresponding component from another corresponding component, and do not limit the corresponding components in view of other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

The term "module" used in various embodiments of the present document may include a unit implemented in hardware, software, or firmware and be used interchangeably with terms such as e.g., logic, logic block, part, component, or circuitry, for example. The module or unit may be a minimum unit or a part of the integrally configured component or the component that performs one or more functions. For example, according to an embodiment, the module or unit may be implemented in the form of an application-specific integrated circuit (ASIC).

## Claims

1.  An electronic device (101) comprising:

    a display panel (210);
    a printed circuit board (220);
    a display driver integrated circuit, DDI, (230) electrically coupled to the display panel (210) and the printed circuit board (220), and configured to control driving of the display panel (210);
    a frame (30) comprising a metal material along an outer rim of the electronic device (101); and
    a conductive tape (600a, 600b) configured to cover the DDI (230) between the DDI (230) and the frame (30) so as to block a radio signal from being transmitted to the DDI (230),
    wherein the frame (30) comprises segments (3111, 3112) made of a non-metallic material in a portion of the frame (30) to be used as an antenna in order to transmit and receive the radio signal at a position of the outer rim,
    **characterized in that**
    the conductive tape (600a, 600b) comprises a slit (610a, 610b, 620a, 620b) facing a segment (3111, 3112) (3111, 3112), and having a predetermined space, the slit (610a, 610b, 620a, 620b) being configured to prevent deterioration in the antenna performance.

2.  The electronic device (101) of claim 1, wherein the conductive tape (600a, 600b) is formed to meet a direction normal to an inner surface of a lower end of the frame (30) and parallel to the display panel (210), and
    wherein the conductive tape (600a, 600b) is grounded.

3.  The electronic device (101) of claim 1 or 2, wherein one side of the slit (610a, 610b, 620a, 620b) is arranged to face an inner surface of a target segment (3111) of the segments (3111, 3112), and

wherein a length of one side facing an inner surface of the slit (610a, 610b, 620a, 620b) is greater than or equal to a width of the target segment (3111).

4. The electronic device (101) of any one of the preceding claims, wherein the slit (610a, 610b, 620a, 620b) is formed of a non-conductive material and/or
wherein a number of the segments (3111, 3112) is equal to or greater than a number of the slits (610a, 610b, 620a, 620b).

5. The electronic device (101) of any one of the preceding claims, wherein a width of the slit (610a, 610b, 620a, 620b) is configured in a shape so that the width is either constant or narrower as it goes away from one end facing an inner surface of one of the segments (3111, 3112), and/or
wherein the slit (610a, 610b, 620a, 620b) has a triangular shape, a quadrilateral shape or a semi-circular shape.

6. The electronic device (101) of any one of the preceding claims, wherein a transverse length of one end of the slit (610a, 610b, 620a, 620b) facing an inner surface of any one of the segments (3111, 3112) is equal to or greater than a transverse length of the segment.

7. The electronic device (101) of any one of the preceding claims, wherein the electronic device (101) is grounded in a specific area of the conductive tape (600a, 600b).

8. The electronic device (101) of any one of the preceding claims, further comprising at least one feeder,
wherein the feeder is electrically coupled to any one of the segments (3111, 3112).

9. The electronic device (101) of any one of the preceding claims, wherein the slit (610a, 610b, 620a, 620b) has a width equal to or wider than that of the segment (3111).

10. The electronic device (101) of any one of the preceding claims, wherein the slit (610a, 610b, 620a, 620b) is provided in the conductive tape (600a, 600b) based on a region on which radiation energy is concentrated in the segment.

11. The electronic device (101) of any one of the preceding claims, wherein at least one of a position of the slit (610a, 610b, 620a, 620b) provided in the conductive tape (600a, 600b), a width of the slit (610a, 610b, 620a, 620b), or a depth of the slit (610a, 610b, 620a, 620b) is determined based on a region on which radiation energy is concentrated in the segment.

**Patentansprüche**

1. Elektronische Vorrichtung (101), umfassend:

ein Anzeigefeld (210);
eine Leiterplatte (220);
eine integrierte Anzeigetreiberschaltung, DDI, (230), die elektrisch mit dem Anzeigefeld (210) und der Leiterplatte (220) verbunden und dazu konfiguriert ist, den Antrieb des Anzeigefelds (210) zu steuern;
einen Rahmen (30), der entlang eines Außenrandes der elektronischen Vorrichtung (101) ein Metallmaterial umfasst; und
ein leitfähiges Band (600a, 600b), das dazu konfiguriert ist, die DDI (230) zwischen der DDI (230) und dem Rahmen (30) abzudecken, um zu verhindern, dass ein Funksignal an die DDI (230) gesendet wird,
wobei der Rahmen (30) Segmente (3111, 3112) aus einem nichtmetallischen Material in einem Abschnitt des Rahmens (30) umfasst, der als Antenne verwendet wird, um das Funksignal an einer Position des Außenrandes zu senden und zu empfangen, **dadurch gekennzeichnet, dass**
das leitfähige Band (600a, 600b) einen Schlitz (610a, 610b, 620a, 620b) umfasst, der einem Segment (3111, 3112) (3111, 3112) zugewandt ist und einen vorbestimmten Raum aufweist, wobei der Schlitz (610a, 610b, 620a, 620b) so konfiguriert ist, dass er eine Verschlechterung der Antennenleistung verhindert.

2. Elektronische Vorrichtung (101) nach Anspruch 1, wobei das leitfähige Band (600a, 600b) so ausgebildet ist, dass es einer Richtung entspricht, die senkrecht zu einer Innenfläche eines unteren Endes des Rahmens (30) und parallel zum Anzeigefeld (210) verläuft, und
wobei das leitfähige Band (600a, 600b) geerdet ist.

3. Elektronische Vorrichtung (101) nach Anspruch 1 oder 2, wobei eine Seite des Schlitzes (610a, 610b, 620a, 620b) so angeordnet ist, dass sie einer Innenfläche eines Zielsegments (3111) der Segmente (3111, 3112) zugewandt ist, und wobei eine Länge einer Seite, die einer Innenfläche des Schlitzes (610a, 610b, 620a, 620b) zugewandt ist, größer oder gleich einer Breite des Zielsegments (3111) ist.

4. Elektronische Vorrichtung (101) nach einem der vorstehenden Ansprüche, wobei der Schlitz (610a, 610b, 620a, 620b) aus einem nichtleitenden Material gebildet ist, und/oder
wobei eine Anzahl der Segmente (3111, 3112) gleich oder größer als eine Anzahl der Schlitze (610a, 610b, 620a, 620b) ist.

5. Elektronische Vorrichtung (101) nach einem der vorstehenden Ansprüche, wobei eine Breite des Schlitzes (610a, 610b, 620a, 620b) in einer Form konfiguriert ist, so dass die Breite entweder konstant oder schmaler ist, wenn sie sich von einem Ende entfernt, das einer Innenfläche eines der Segmente (3111, 3112) zugewandt ist, und/oder
wobei der Schlitz (610a, 610b, 620a, 620b) eine dreieckige Form, eine viereckige Form oder eine halbkreisförmige Form aufweist.

6. Elektronische Vorrichtung (101) nach einem der vorstehenden Ansprüche, wobei eine Querlänge eines Endes des Schlitzes (610a, 610b, 620a, 620b), das einer Innenfläche eines beliebigen der Segmente (3111, 3112) zugewandt ist, gleich oder größer als eine Querlänge des Segments ist.

7. Elektronische Vorrichtung (101) nach einem der vorstehenden Ansprüche, wobei die elektronische Vorrichtung (101) in einem spezifischen Bereich des leitfähigen Bandes (600a, 600b) geerdet ist.

8. Elektronische Vorrichtung (101) nach einem der vorstehenden Ansprüche, umfassend ferner mindestens einen Zuführer,
wobei der Zuführer elektrisch mit einem beliebigen der Segmente (3111, 3112) gekoppelt ist.

9. Elektronische Vorrichtung (101) nach einem der vorstehenden Ansprüche, wobei der Schlitz (610a, 610b, 620a, 620b) eine Breite aufweist, die gleich oder größer als die des Segments (3111) ist.

10. Elektronische Vorrichtung (101) nach einem der vorstehenden Ansprüche, wobei der Schlitz (610a, 610b, 620a, 620b) in dem leitfähigen Band (600a, 600b) auf der Grundlage eines Bereichs vorgesehen ist, auf dem Strahlungsenergie in dem Segment konzentriert ist.

11. Elektronische Vorrichtung (101) nach einem der vorstehenden Ansprüche, wobei mindestens eine von einer Position des in dem leitfähigen Band (600a, 600b) vorgesehenen Schlitzes (610a, 610b, 620a, 620b), einer Breite des Schlitzes (610a, 610b, 620a, 620b) und einer Tiefe des Schlitzes (610a, 610b, 620a, 620b) auf der Grundlage eines Bereichs bestimmt wird, auf dem Strahlungsenergie in dem Segment konzentriert ist.

**Revendications**

1. Dispositif électronique (101) comprenant :

   un panneau d'affichage (210) ;
   un circuit imprimé (220) ;
   un circuit intégré de commande d'affichage, DDI, (230) électriquement couplé au panneau d'affichage (210) et au circuit imprimé (220), et configuré pour commander l'entraînement du panneau d'affichage (210) ;
   un cadre (30) comprenant un matériau métallique le long d'un bord externe du dispositif électronique (101) ; et
   un ruban conducteur (600a, 600b) configuré pour recouvrir le DDI (230) entre le DDI (230) et le cadre (30) de manière à empêcher la transmission d'un signal radio vers le DDI (230),
   dans lequel le cadre (30) comprend des segments (3111, 3112) réalisés en matériau non métallique dans une partie du cadre (30) destinée à être utilisée comme antenne afin de transmettre et de recevoir le signal radio au niveau du bord externe, **caractérisé en ce que** :
   le ruban conducteur (600a, 600b) comprend une fente (610a, 610b, 620a, 620b) faisant face à un segment (3111, 3112) (3111, 3112), et présentant un espace prédéterminé, la fente (610a, 610b, 620a, 620b) étant configurée pour éviter une dégradation des performances de l'antenne.

2. Dispositif électronique (101) selon la revendication 1, dans lequel le ruban conducteur (600a, 600b) est formé de manière à être orienté selon une direction normale à une surface interne d'une extrémité inférieure du cadre (30) et parallèle au panneau d'affichage (210), et
dans lequel le ruban conducteur (600a, 600b) est relié à la masse.

3. Dispositif électronique (101) selon la revendication 1 ou 2, dans lequel un côté de la fente (610a, 610b, 620a, 620b) est disposé en regard d'une surface interne d'un segment cible (3111) parmi les segments (3111, 3112), et
dans lequel une longueur dudit côté en regard de la surface interne de la fente (610a, 610b, 620a, 620b) est supérieure ou égale à une largeur du segment cible (3111).

4. Dispositif électronique (101) selon l'une quelconque des revendications précédentes, dans lequel la fente (610a, 610b, 620a, 620b) est formée d'un matériau non conducteur et/ou
dans lequel le nombre de segments (3111, 3112) est supérieur ou égal au nombre de fentes (610a, 610b, 620a, 620b).

5. Dispositif électronique (101) selon l'une quelconque des revendications précédentes, dans lequel une largeur de la fente (610a, 610b, 620a, 620b) est configurée de sorte qu'elle soit constante, soit décroissante à mesure qu'elle s'éloigne d'une extrémité faisant face à une surface interne de l'un des segments (3111, 3112), et/ou
dans lequel la fente (610a, 610b, 620a, 620b) présente une forme triangulaire, quadrilatérale ou semi-circulaire.

6. Dispositif électronique (101) selon l'une quelconque des revendications précédentes, dans lequel une longueur transversale d'une extrémité de la fente (610a, 610b, 620a, 620b) faisant face à une surface interne de l'un quelqueconque des segments (3111, 3112) est supérieure ou égale à une longueur transversale dudit segment.

7. Dispositif électronique (101) selon l'une quelconque des revendications précédentes, dans lequel le dispositif électronique (101) est relié à la masse dans une zone spécifique du ruban conducteur (600a, 600b).

8. Dispositif électronique (101) selon l'une quelconque des revendications précédentes, comprenant en outre au moins un feeder,
dans lequel le feeder est électriquement couplé à l'un quelqueconque des segments (3111, 3112).

9. Dispositif électronique (101) selon l'une quelconque des revendications précédentes, dans lequel la fente (610a, 610b, 620a, 620b) présente une largeur égale ou supérieure à celle du segment (3111).

10. Dispositif électronique (101) selon l'une quelconque des revendications précédentes, dans lequel la fente (610a, 610b, 620a, 620b) est formée dans le ruban conducteur (600a, 600b) en fonction d'une région dans laquelle l'énergie de rayonnement est concentrée dans le segment.

11. Dispositif électronique (101) selon l'une quelconque des revendications précédentes, dans lequel au moins une parmi une position de la fente (610a, 610b, 620a, 620b) formée dans le ruban conducteur (600a, 600b), une largeur de la fente (610a, 610b, 620a, 620b) ou une profondeur de la fente (610a, 610b, 620a, 620b) est déterminé en fonction d'une région dans laquelle l'énergie de rayonnement est concentrée dans le segment.

# FIG.1

EP 4 280 837 B1

# FIG.2

200

DISPLAY MODULE (160)

DISPLAY DRIVER IC (230)

INTERFACE MODULE (231)

MEMORY (233)

IMAGE PROCESSING MODULE (235)

MAPPING MODULE (237)

DISPLAY (210)

TOUCH CIRCUITRY (250)

TOUCH SENSOR (251)

TOUCH SENSOR IC (253)

SENSOR MODULE (176)

# FIG.3

# FIG.4

# *FIG.5A*

# FIG.5B

# FIG.6

# FIG.7A

# FIG.7B

# FIG.8

# FIG.9A

# FIG.9B

# FIG.10A

# *FIG.10B*

# *FIG.11A*

# FIG.11B

# *FIG.11C*

# FIG.11D

# *FIG.11E*

# FIG.11F

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2021168973 A1